# EUROPEAN PATENT APPLICATION

(11) **EP 1 598 387 A1**
(43) Date of publication of application: **23.11.2005**
(21) Application number: 04714381.3
(22) Date of filing: 25.02.2004
(51) Int. Cl.: C08G 77/04, C07F 7/12, H01L 51/00, H01L 29/786

(54) **FUNCTIONAL ORGANIC THIN FILM, ORGANIC THIN-FILM TRANSISTOR, PI-ELECTRON CONJUGATED MOLECULE-CONTAINING SILICON COMPOUND, AND METHODS OF FORMING THEM**

(30) Priority: 25.02.2003 JP 2003047746; 26.03.2003 JP 2003086257; 27.03.2003 JP 2003088680
(71) Applicant: SHARP KABUSHIKI KAISHA, Osaka-shi, Osaka 545-8522 (JP)
(72) Inventor: HANATO, Hiroyuki, Nara-shi, Nara 6310044 (JP); NAKAGAWA, Masatoshi, Nara-shi, Nara 6308133 (JP); TAMURA, Toshihiro, Shiki-gun, Nara 6360302 (JP)
(74) Representative: Müller - Hoffmann & Partner
(86) International application number: PCT/IB2004/000475
(87) International publication number: WO 2004/085515

(57) **Abstract**

An organic thin film having both a chemical structure of an organic material that is a factor determining a characteristic of the thin film and a high-order structure of the thin film, for example, the crystallinity of molecules, namely, the orientation. A functional organic thin film composed of molecules the main skeleton structure portion of which is arbitrarily given electrical, optical, electrochemical function and a method for simply forming such a functional organic thin film are also disclosed. The functional organic film is formed of a silicon compound expressed by formula R¹-SiX¹X²X³ (I) ,where R is an organic residue which may have a terminal replaced by a functional grou p and to which π -electron conjugate units are bonded, and X¹, X² and X³ are the same group or different groups and given a hydroxyl group by hydrolysis.

## Description

### TECHNICAL FIELD

The present invention relates to a functional organic thin film, an organic thin film transistor, a π-electron conjugated molecule-containing silicon compound, and a method of forming them. More particularly, the present invention relates to the functional organic thin film using the π-electron conjugated molecule-containing silicon compound having property such as electric conductivity, the organic thin film transistor using the π-electron conjugated molecule-containing silicon compound in a semiconductor layer, the π-electron conjugated molecule-containing silicon compound and the method of forming them.

### BACKGROUND ART

Recently, semiconductors using organic compounds (organic semiconductor) have been researched and developed, and outcome thereof has been reported. Because when compared with semiconductors of inorganic materials, the organic semiconductors are simple to manufacture, are easy to process, can response to enlargement of a device, can expect for cost down due to mass production, and can synthesize organic compounds having more versatile functions than that of inorganic materials.

Inter alia, it is known that TFT having a great mobility can be manufactured by utilizing an organic compound containing a π -electron conjugated molecule. As this organic compound, as a representative, a pentacene has been reported (e.g. IEEE Electron Device Lett., 18, 606-608 (1997)). Therein, it has been reported that, when a pentacene is used to form an organic semiconductor layer and then TFT, it is possible to construct TFT having a greater mobility than that of amorphous silicon, because its field-effect mobility becomes 1.5cm²/Vs.

However, when the organic compound semiconductor layer for obtaining a higher field-effect mobility than that of the aforementioned amorphous silicon is prepared, it needs a vacuum process such as a resistance heating deposition method and a molecule beam deposition method leading that its manufacturing step becomes troublesome and, at the same time, a film having crystallizability is obtained only under a particular condition. In addition, the organic compound film is adsorbed onto a substrate by physical adsorption which is low at strength, and is easily peeled. Further, in order to control molecular orientation of the organic compound in the film to a certain degree, a substrate on which the film is formed is usually in advance subjected to orientation controlling by rubbing treatment. However, in making the film by physical adsorption, there is no report that compatibility and orientation property of a molecule at an interface between a physical adsorbed organic compound and the substrate can be controlled.

On the other hand, regarding regularity and crystallizability of the film greatly influencing on a field-effect mobility which is a representative index of property of this TFT, since it is simple to manufacture the film, a self-organizing film using an organic compound has been recently paid an attention, and utilization of the film has been studied.

The self-organizing film is binding of a part of the organic compound to a functional group on the substrate surface, and is a film having an extremely little defect, and having high ordering property, that is, crystallizability. Since this self-organizing film is extremely simple to manufacture it, it is easy to make a film on the substrate. A thiol film formed on a gold substrate, and a silicon-based compound film formed on a substrate on which hydroxyl group can be protruded on a surface by hydrophilization treatment (e.g. silicon substrate) are known as usual self-organizing films. Inter alia, from a viewpoint of high durability, the silicon-based compound film is paid an attention. The silicon-based compound film has been previously used as a water-repellent coating, and the film has been made using a silane coupling agent having an alkyl group of a high water-repellent effect or a fluorinated alkyl group as an organic functional group.

However, although electric conductivity of the self-organizing film is determined by an organic functional group in the silicon-based compound contained in the film, there are no commercially available silane coupling agents which have an organic functional group containing π -electron conjugated molecule and, for this reason, it is difficult to impart electric conductivity to the self-organizing film. Therefore, it is expected that the silicon-based compound containing the π -electron conjugated molecule as the organic functional group which is suitable in a device such as TFT is available.

As such the silicon-based compound, a compound having one thiophene ring as a functional group at a terminal of a molecule in which a thiophene ring is bound to a silicon atom via a linear hydrocarbon group has been proposed (e.g. Japanese Patent No.2889768). Further, as a polyacetylene film, a film in which a part of acetylene group is polymerized on a substrate by forming a -Si-O- network by a chemical adsorption method has been proposed (e.g. Japanese Examined Patent Publication No. HEI 6(1994)-27140). In addition, there is a proposal that, as an organic material, is used a silicon compound in which linear hydrocarbon groups are bonded to the 2- and 5- positions of thiophene ring respectively and a terminus of the linear hydrocarbon and a silanol group are bound. This silicon compound is self-organized on a substrate, and further polymerized by field-polymerized to form an electrically conductive thin film, which is used as a semiconductor layer (e.g. Japanese Patent No. 2507153). Further, a field-effect transistor utilizing a semiconductor thin film containing, as a main component, a silicon compound having a silanol group on thiophene ring contained in polythiophene has been proposed (e.g. Japanese Patent No. 2725587).

However, although the afore-proposed compounds can manufacture a self-organized film which can be chemically adsorbed onto a substrate, a film having high ordering property, crystallizability and electric conductive property which can be used in an electronic device such as TFT could not be necessarily manufactured. Further, when the above-proposed compounds are used in a semiconductor layer of organic TFT, there is a problem that an off current becomes great. This is thought that all of proposed compounds have a bond in a molecular direction and a direction vertical to a molecule.

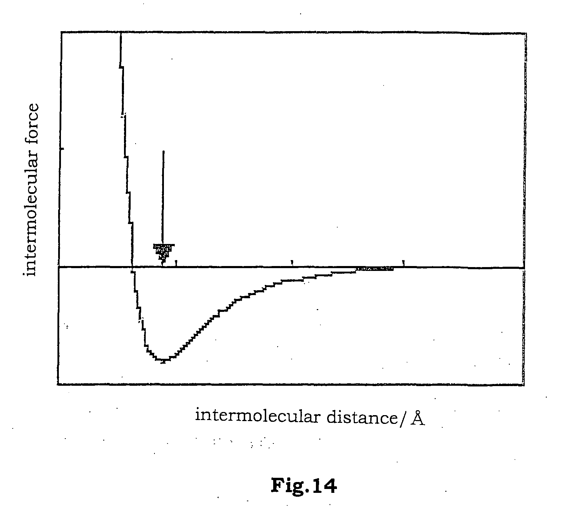

In order to obtain high ordering property, that is, high crystallizability, it is necessary that high attractive interaction exerts between molecules. An intermolecular force is composed of an attraction term and a repulsion term, the former is inverse proportion to an intermolecular distance to the power of six, and the latter is inverse proportion to an intermolecular distance to the power of twelve. Therefore, an intermolecular force which is a sum of an attraction term and a repulsion term has a relationship shown in Fig. 14. Herein, a minimum point in Fig 14 (arrow part in the figure) is an intermolecular distance when the highest attraction is exerted between molecules from a balance between an attraction term and a repulsion term. That is, in order to obtain higher crystallizability, it is important that an intermolecular distance approaches a minimum point as near as possible. Therefore, originally, in a vacuum process such as a resistance heating deposition method and a molecular beam deposition method, only under particular conditions, high ordering property, that is, crystallizability is obtained by skillfully controlling intermolecular interaction between π -electron conjugated molecules. Like this, it becomes possible to manifest high electric conductive property only by crystallizability constructed by intermolecular interaction.

On the other hand, there is a possibility that the aforementioned compound is chemically adsorbed onto a substrate by forming a two-dimensional network of Si-O-Si, by which ordering property is obtained by intermolecular interaction between particular long chain alkyls. However, since only one thiophene molecule which is a functional group contributes to a π -electron conjugation system, there is a problem that intermolecular interaction is weak, and expansion of a π -electron conjugation system indispensable for electric conductivity is very small. Even when the number of thiophene molecules which are the aforementioned functional group can be increased, it is difficult that a factor forming ordering property of the film can match intermolecular interaction between a long chain alkyl part and a thiophene part.

Further, as electric conductive property, one thiophene molecule which is a functional group, is great at its HOMO-LUMO energy gap and hence there was a problem that even when the molecule is used as an organic semiconductor layer in TFT, sufficient carrier mobility cannot be obtained.

### DISCLOSURE OF THE INVENTION

The present invention was done in view of the aforementioned problems, and an object of the present invention is to provide a compound which can be easily crystallized to form a film by a simple process, in which the resulting film is firmly adsorbed onto a substrate surface to prevent physical peeling, and shows a high ordering property, crystallizability and electric conductive property.

Another object of the present invention is to provide a functional organic thin film by arbitrarily imparting electrical, optical and electrooptical functionality to a main skeleton part of a molecule in a compound constituting a film.

A further object of the present invention is to provide TFT having high performance and high reliance by maintaining a sufficient carrier mobility and suppressing an off current in TFT using an organic thin film.

In order to attain the aforementioned objects, the present inventors have intensively studied and found that, in order to prepare an organic thin film applicable to an electronic device such as TFT, firm chemical binding with a substrate is possible by forming a two-dimensional network of Si-O-Si and, at the same time, ordering property (crystallizability) of the organic thin film can be controlled by interaction of a molecule (herein, π -electron conjugated molecule) formed on the two-dimensional network of Si-O-Si, that is, an intermolecular force, resulting in the present invention.

Thus, according to the present invention, there is provided a functional organic thin film comprising a film made on a substrate using a silicon compound represented by the formula: R-SiX¹X²X³ (I) ,wherein R is an organic residue in which a plurality of π -electron conjugated units having a terminus optionally substituted with a functional group are bound, and X¹, X² and X³ are the same or different and each is a group which affords hydroxyl group by hydrolysis.

Also, according to the present invention, there is provided a process for preparing a functional organic thin film comprising forming a functional organic thin film on a substrate by a chemical adsorption method using a silicon compound represented the formula:

R-SiX¹X²X³ (I)

,wherein R, X¹, X² and X³ are as defined above.

Further, according to the present invention, there is provided a functional organic thin film comprising a first monomolecular film derived from a silicon compound represented by the formula:

R-SiX¹X²X³ (I)

,wherein R, X¹, X² and X³ are as defined above,
and a second monomolecular film containing a silicon compound in which a plurality of π -electron conjugated units are bound on a substrate, said second monomolecular film being formed on the first monomolecular film at the number of one or more.

Also, according to the present invention, there is provided a process for preparing a functional organic thin film comprising steps of: making a first monomolecular film on a substrate by a chemical adsorption method using a silicon compound represented by the formula:

R-SiX¹X²X³ (I)

,wherein R, X¹, X² and X³ are as defined above, and forming at least one second monomolecular film containing a silicon compound in which a plurality of π -electron conjugated units are bound, on the first monomolecular film using a chemical adsorption method.

Further, according to the present invention, there is provided an organic thin film transistor comprising a substrate, an organic thin film of a monomolecular film of a silicon compound represented by the formula:

R-SiX¹X²X³ (I)

,wherein R, X¹, X² and X³ are as defined above, or an accumulated monomolecular film a gate electrode which is formed on one surface of the organic thin film via a gate insulating film, and source/drain electrodes formed in contact with one surface or the other surface of the organic thin film on both sides of the gate electrode.

Further, according to the present invention, there is provided an organic thin film transistor comprising a substrate, an organic thin film, a gate electrode formed on one surface of the organic thin film via an insulating film, and source/drain electrodes formed in contact with one surface or the other surface of the organic thin film on both sides of the gate electrode, wherein the organic thin film comprises a first monomolecular film formed using a silicon compound represented by the formula:

R-SiX¹X²X³ (I)

, wherein R, X¹, X² and X³ are as defined above,
and at least one second monomolecular film containing a silicon compound in which a plurality of π -electron conjugated units are bound, formed on the first monomolecular film.

Also, according to the present invention, there is provided a process for preparing an organic thin film transistor comprising a substrate, an organic thin film, a gate electrode formed on one surface of the organic thin film via a gate insulating film, and source/drain electrodes formed in contact with one surface or the other surface of the organic thin film on both sides of the gate electrode, which comprises forming the organic thin film as a monomolecular film or an accumulated monomolecular film using a silicon compound represented by the formula:

R-SiX¹X²X³ (I)

,wherein R, X¹, X² and X³ are as defined above.

Further, according to the present invention, there is provided a process for preparing an organic thin film transistor comprising a substrate, an organic thin film, a gate electrode formed on one surface of the organic thin film via a gate insulating film, and source/drain electrodes formed in contact with one surface or the other surface of the organic thin film on both sides of the gate electrode, which comprises steps of
making a first monomolecular film on a substrate by a chemical absorption method using a silicon compound represented by the formula:

R-SiX¹X²X³ (I)

,wherein R, X¹, X² and X³ are as defined above, and
forming at least one second monomolecular film comprising a silicon compound in which a plurality of π -electron conjugated units are bound, on the first monomolecular film using a chemical adsorption method.

Also, as a preferable compound included in the formula(I), there is provided a π -electron conjugated molecule-containing silicon compound represented by the formula:

R¹-SiX¹X²X³ (I)'

,wherein R¹ is a π -electron conjugated organic residue in which 3 to 10 units selected from the group derived from a monocyclic aromatic hydrocarbon and a monocyclic heterocycle compounds are bound, and may have a functional group at a terminus, and X¹, X² and X³ are as defined above.

Also, according to the present invention, a process for preparing a compound of the formula (I)' is provided. That is, there is provided a process for preparing a π -electron conjugated molecule-containing silicon compound comprising reacting a compound represented by the formula:

R¹-Li (II)'

,wherein R¹ is as defined above,
and a compound represented by the formula:

Y-SiX¹X²X³ (III)'

,wherein X¹, X² and X³ are as defined above, and Y is a hydrogen atom, a halogen atom or a lower alkoxy group,
to obtain a π -electron conjugated molecule-containing silicon compound represented by the formula:

R¹-SiX¹X²X³ (I)'

,wherein R¹, X¹, X² and X³ are as defined above.

Further, according to the present invention, there is provided a process for preparing a π -electron conjugated molecule-containing silicon compound comprising subjecting a compound represented by the formula:

R¹-MgX (IV)'

, wherein R¹ is as defined above,
and a compound represented by the formula:

Y-SiX¹X²X³ (III)'

, wherein X¹, X², X³ and Y are as defined above,
to Grignard reaction to obtain a π -electron conjugated molecule-containing silicon compound represented by the formula:

R¹-SiX¹X²X³ (I)'

, wherein R¹, X¹, X² and X³ are as defined above.

### BRIEF DESCRIPTION OF THE DRAWINGS

Figs. 1 (a) to (c) are conceptual diagrams for explaining film forming method of an accumulated monomolecular film;
Fig. 2 is a conceptual diagram for showing a molecular sequence in a functional organic thin film of the present invention;
Fig. 3 is a schematic cross sectional view of an organic thin film transistor using a silicon compound of the present invention;
Fig. 4 is a schematic view showing a structure for estimating electric conductivity of a film using a silicon compound of the present invention;
Fig. 5 is a schematic view for explaining a measuring method of carrier mobility by a transient photocurrent measuring method;
Fig. 6 is a schematic cross sectional view of an organic thin film transistor using a silicon compound of the present invention;
Fig. 7 is a conceptual diagram for showing a molecular sequence in a functional organic thin film of Fig. 6;
Fig. 8 is a properties chart of an organic thin film transistor according to Example 13 of the present invention;
Fig. 9 is a properties chart of an organic thin film transistor according to Example 14 of the present invention;
Fig. 10 is a properties chart of an organic thin film transistor according to Example 15 of the present invention;
Fig. 11 is a properties chart of an organic thin film transistor according to Example 16 of the present invention;
Fig. 12 is a properties chart of an organic thin film transistor according to Example 17 of the present invention;
Fig. 13 is a properties chart of an organic thin film transistor according to Example 18 of the present invention;
Fig. 14 is a view for explaining a relationship between an intermolecular distance and an intermolecular force.

### BEST MODE FOR CARRYING OUT THE INVENTION

The π -electron conjugated molecule-containing silicon compound of the present invention, (hereinafter, simply referred to as Silicon compound) is represented by the formula (I), that is, R-SiX¹X²X³. In the formula (I), R is a π -electron conjugated organic residue in which 3 to 10 of units selected from groups derived from monocyclic aromatic hydrocarbon and monocyclic heterocycle compound are bound, and may have a functional group at a terminus.

Examples of the monocyclic aromatic hydrocarbon constituting the unit include benzene, toluene, xylene, mesitylene, cumene, cymene, styrene and divinyl benzene, among which benzene is particularly preferable.

Examples of a heteroatom contained in the monocyclic heterocycle compound include oxygen, nitrogen and sulfur. Examples of the specific heterocycle compound include an oxygen containing compound such as furan, a nitrogen containing compound such as pyrrole, pyridine, pyrimidine, pyroline, imidazoline and pyrazoline, a sulfur containing compound such as thiophene, a nitrogen and oxygen containing compound such as oxazole and isooxasole, and a sulfur and nitrogen containing compound such as thiazole and isothiazole. Inter alia, thiophene is particularly preferable.

Three to ten of the aforementioned units are bound to be a π -electron conjugated organic residue. Further, it is preferable that 3 to 8 of the units are bound, taking a yield, economic property and mass production into consideration.

A plurality of these units are preferably bound in straight manner, but may be bound in a branched manner. In addition, the organic residue may comprise the same units, units which are all different or a plurality of kinds of units which may be bound regularly or in a random order. In addition, positions of binding, when a constitutional molecule of a unit is a 5-membered ring, may be any of 2,5-positions, 3,4-positions, 2,3-positions, 2,4-positions and the like, among which 2,5-positions are preferable. In the case of the 6-membered ring, positions of binding may be any of 1,4-positions, 1,2-positions. 1,3-positions and the like, among which 1,4-positions are preferable.

Examples of R include groups derived from biphenyl, bithiophenyl, terphenyl, terthienyl, quaterphenyl, quaterthiophene, quinquephenyl, quinquethiophene, hexyphenyl, hexythiophene, thienyl-oligophenylene (see compound of the formula (3)), phenyl-oligooligothienylene (see compound of the formula (4)), and block oligomer (see compound of the formula (5) or (6)).

The organic residue may have a functional group at a terminus. Specific examples of the functional groups include hydroxyl group, a substituted or unsubstituted amino group, nitro group, cyano group, a substituted or unsubstituted alkyl group, a substituted or unsubstituted alkenyl group, a substituted or susubstituted cycloalkyl group, a substituted or unsubstituted allcoxy group, a substituted or unsubstituted aromatic hydrocarbon group, a substituted or unsubstituted aromatic heterocycle group, a substituted or unsubstituted aralkyl group, a substituted or unsubstituted aryloxy group, a substituted or unsubstituted alkoxycarbonyl group, a carboxyl group and an ester group. Among these functional groups, a functional group which does not inhibit crystallization of an organic thin film due to its steric hindrance is preferable. Therefore, among the aforementioned functional groups, a linear alkyl group of a carbon number of 1 to 30 is particularly preferable.

Further, a vinylene group may be situated between units. Examples of hydrocarbon affording a vinylene group include alkene, alkadiene and alkatriene. Examples of the alkene include a compound of a carbon number of 2 to 4 such as ethylene, propylene and butylenes. Inter alia, ethylene is preferable. Examples of the alkadiene include a compound of a carbon number of 4 to 6 such as butadiene, pentadiene and hexadiene. Examples of the alkatriene include a compound of a carbon number of 6 to 8 such as hexatriene, pentatriene and octatriene.

The group affording hydroxy group by hydrolysis in X¹, X² and X³ is not particularly limited, but examples include a halogen atom and a lower alkoxy group. Examples of the halogen atom include fluorine, chlorine, iodine and bromine atoms. Examples of the lower alkoxy group include an alkoxy group of a carbon number of 1 to 4, such as methoxy group, ethoxy group, n-propoxy group, 2-propoxy group, n-butoxy group, sec-butoxy group and tert-butoxy group. A part of these groups may be substituted with other functional group (trialkylsilyl group, other alkoxy group etc.). X¹, X² and X³ may be the same, and it is not necessarily required that all of them are the same. Two or all of them may be different. Inter alia, it is preferable that all of them are the same.

Examples of Silicon compound of the present invention include the following compounds 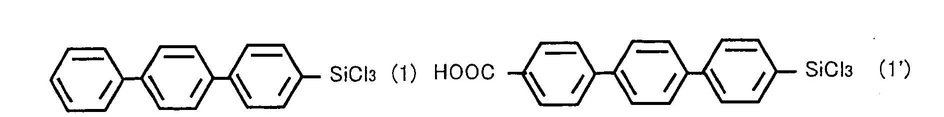 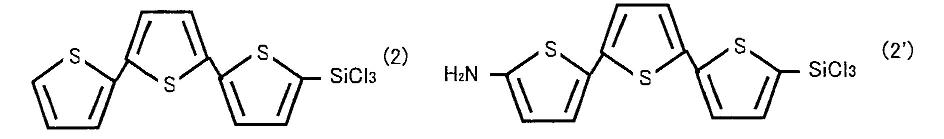 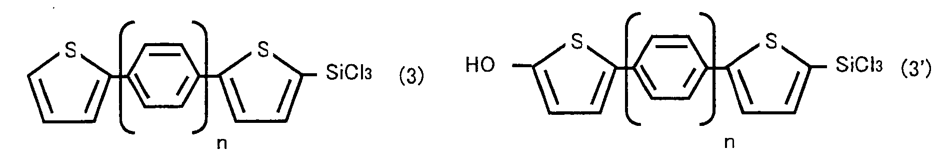 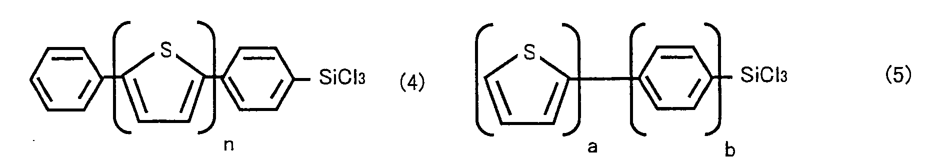 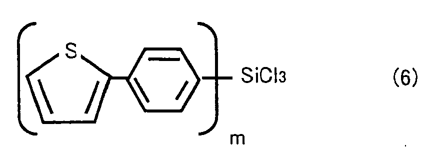 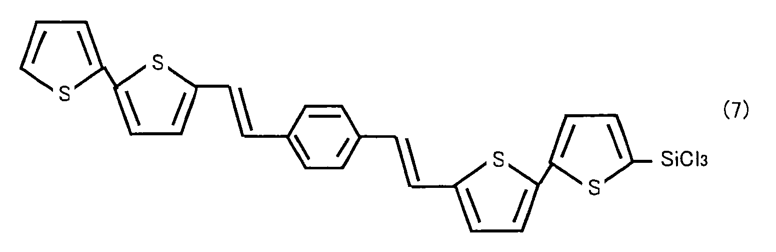 , wherein n is 2 to 8, m is 2 to 5, and a+b is 3 to 10.

A method of synthesizing Silicon compound of the present invention will be explained below.

Silicon compound of the present invention can be obtained :
· by reacting a compound represented by the formula : R-Li (II) and a compound represented by the formula: Y-SiX¹X²X³ (III), wherein X¹, X², X³ and Y are as defined above, or
· by subjecting a compound represented by the formula: R-MgX (IV), wherein R and X are as defined above, and a compound represented by the formula (III) to Grignard reaction.

The compound of the formula (II) or (IV) can be obtained, for example, by reacting a compound represented by RH and an alkyllithium, or by reacting a compound represented by R-X (X is a halogen atom) and an alkylmagnesium halide or a metallic magnesium.

Examples of the alkyllithium used in this reaction include a lower alkyllithium (carbon number around 1 to 4) such as n-butyllithium, s-butyllithium and t-butyllithium. Its use amount is preferably 1 to 5 moles, more preferably 1 to 2 moles relative to 1 mole of the compound RH. Examples of the alkylmagnesium halide include ethylmagnesium bromide and methylmagnesium chloride. Its use amount is preferably 1 to 10 moles, more preferably 1 to 4 moles relative to 1 mole of a raw material compound R-X.

The reaction temperature is, for example, preferably -100 to 150°C, more preferably -20 to 100°C. The reaction time is, for example, around 0.1 to 48 hours. The reaction is usually carried out in an organic solvent having no influence on the reaction. Examples of the organic solvent having no adverse influence on the reaction include aliphatic or aromatic hydrocarbons such as hexane, pentane, benzene and toluene, and ether solvents such as diethyl ether, dipropyl ether, dioxane and tetrahydrofuran (THF). These may be used alone or in a combination of them. Inter alia, diethyl ether and THF are preferable. In the reaction, a catalyst is optionally used. The catalyst can be used the known catalyst such as a platinum catalyst, a palladium catalyst and a nickel catalyst.

A method of synthesizing Silicon compound of the present invention will be explained more specifically below. The reaction temperature and the reaction time in the following synthetic method are the same as those described above, for example, -100 to 150°C, and 0.1 to 48 hours.

Hereinafter, an example of synthesizing a precursor of an organic residue composed of a unit derived from benzene which is an example of the monocyclic aromatic hydrocarbon, and a unit derived from thiophene which is an example of the monocyclic heterocycle compound will be shown. In this respect, a precursor of a heterocycle compound containing a nitrogen atom or an oxygen atom can be formed by the same method as that for a nitrogen-containing heterocycle compound such as thiophene.

As a method of synthesizing a precursor composed of a unit derived from benzene or thiophene, first, it is effective to halogenate a reaction site of benzene or thiophene and then subject to Grignard reaction. By using this method, a precursor in which the number of benzene or thiophene is controlled can be synthesized. Alternatively, in addition to a method of applying Grignard reagent, the precursor can be also synthesized by coupling, utilizing a suitable metal catalyst (Cu, Al, Zn, Zr, Sn etc.).

Further, regarding thiophene, in addition to a method of utilizing Grignard reagent, the following synthetic method can be utilized.

That is, first, 2'-position or 5'-position of thiophene is halogenated (e.g. chlorinated). Examples of the halogenating method include treating with one equivalent of N-chlorosuccinimide (NCS) or with phosphorus oxychloride (POCl₃). As a solvent thereupon, for example, a chloroform-acetic acid (AcOH) mixed solution or DMF can be used. Alternatively, by reacting halogenated thiophenes in DMF solvent using tris(triphenylphosphine) nickel ((PPh₃)3Ni) as a catalyst, consequently, thiophenes can be directly bound at a halogenated part.

Further, by adding divinyl sulfone to halogenated thiophene to couple them, a 1,4-diketone compound is formed. Subsequently, Lawesson Reagent (LR) or P₄S₁₀ is added, and the mixture is refluxed in a dry toluene solution overnight in the case of the former, or for about 3 hours in the case of the latter, causing a ring closing reaction. As a result, a precursor in which the number of thiophenes is larger than a sum of the number of coupled thiophenes by one can be synthesized.

Utilizing the above reaction of thiophene, the number of thiophene rings can be increased.

A terminus of the precursor can be halogenated like a raw material used for synthesizing it. For this reason, after the precursor is halogenated, for example, it is reacted with SiCl₄, yielding a Silicon compund having a silyl group at a terminus and provided with an organic residue composed only of a unit derived from benzene or thiophene (simple benzene or simple thiophene compound).

One example of a method of synthesizing a precursor of an organic residue composed only of benzene or thiophene, and one example of a method of silylating a precursor are shown in the following (A) to (D). In the following example of synthesis of a precursor composed only of thiophene, only a reaction from a trimer of thiophene to a 6-mer or 7-mer is shown. However, when reacted with thiophene having a different unit number, a precursor other than the 6-mer or 7-mer can be formed. For example, after 2-chlorothiophene is coupled, 2-chlorobithiophene chlorinated with NCS is subjected to the following reaction, thereby, a tetramer or a 5-mer of thiophene can be formed. Further, when a thiophene tetramer is chlorinated with NCS, a thiophene 8-mer or 9-mer can be also formed.

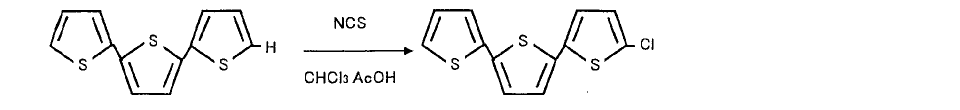

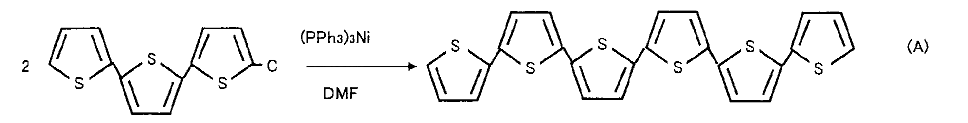

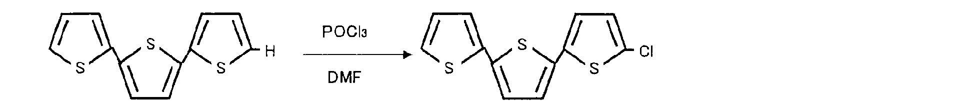

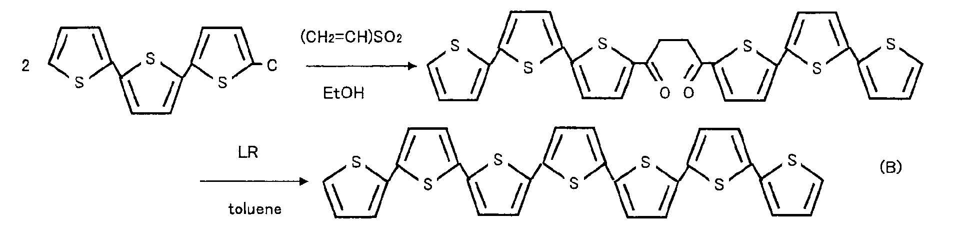

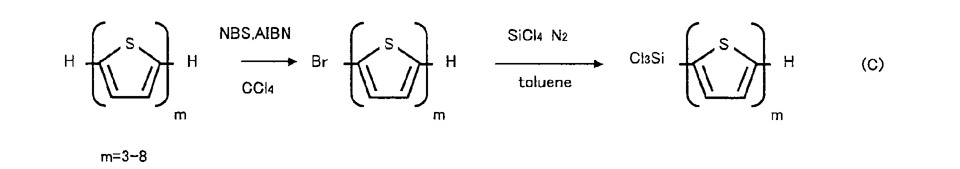

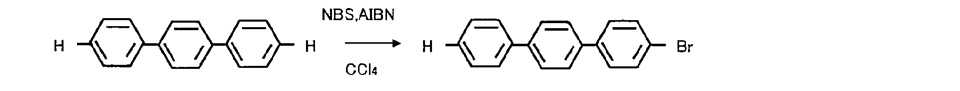

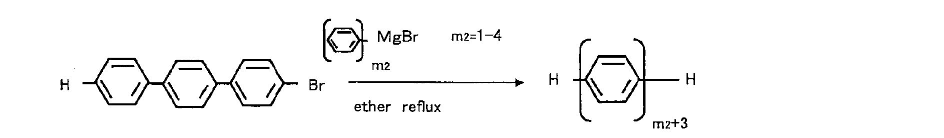

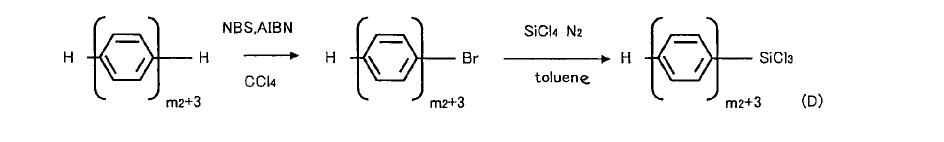

As a method of obtaining a precursor of a block-type organic residue by directly binding units in which a prescribed number of thiophene-derived unit and a prescribed number of benzene-derived unit are bound, there is, for example, a method using Grignard reaction. In addition, when a precursor is reacted with SiCl₄ or HSi(OEt)₃, an objective silicon compound can be obtained. In addition, among the aforementioned compounds, since a compound having a terminal alkoxy group at single group has relatively low reactivity, the compound can be synthesized in the state where it is bound to a raw material in advance. As a synthesis example in this case, the following method can be applied.

Firstly, a simple benzene or thiophene having silyl group is halogenated (e.g. brominated) at a reverse terminus to the silyl group and subjected to Grignard reaction, thereby converting the halogen as a functional group to be bound to the silyl group into alkoxy group. Subsequently, by adding n-BuLi and B(O-iPr)₃, this can be debrominated and boronized. As a solvent thereupon, ether is preferable. In addition, the boronization is 2-stages where the first stage is preferably performed at -78°C in order to initially stabilize the reaction, and the second stage is gradually elevated from -78°C to room temperature. Separately, an intermediate of a block-type compound is prepared from Grignard reaction using benzene or thiophene having a halogen group (e.g. bromo group) at both terminals.

In this state, when the aforementioned boronized compound having an unreacted bromo group is put, for example, in a toluene solvent, the reaction is completely proceeded at a temperature of 85°C in the presence of Pd(PPh₃)₄ and Na₂CO₃, to cause the coupling. Consequently, Silicon compound having a silyl group at a terminal of a block-type compound can be synthesized.

One example of the route for synthesizing Silicon compounds (E) and (F) using such the reaction is shown below. A compound having a halogen group (e.g. bromo group) and a trichlorosilyl group, respectively, at both terminuses of a benzene or thiophene-derived unit can be formed by halogenating both terminuses by the reaction of p-phenylene or 2,5-thiophenediyl and a halogenating agent (e.g. NBS) and, thereafter, reacting this with SiCl₄ to trichlorosilylate one of the terminuses.

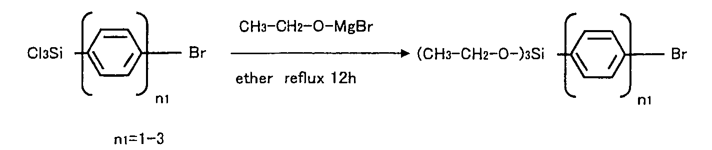

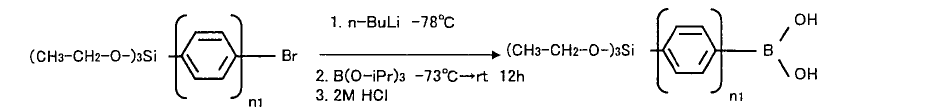

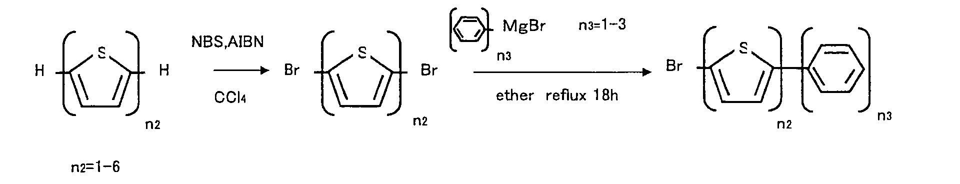

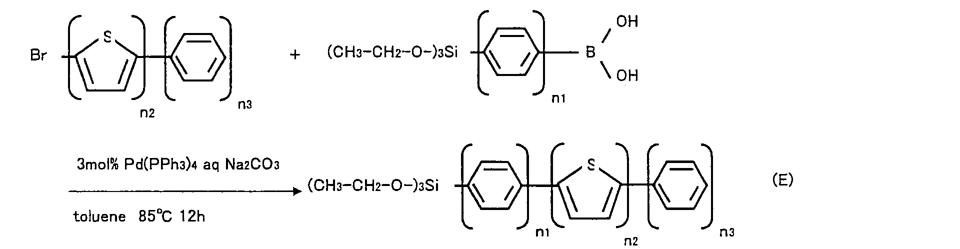

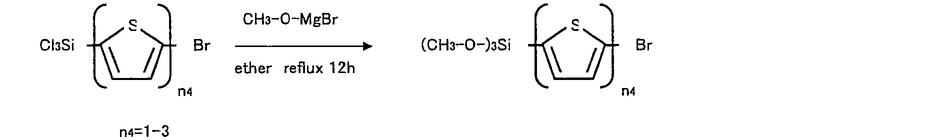

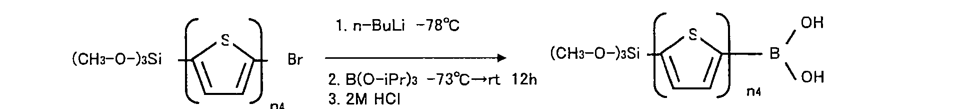

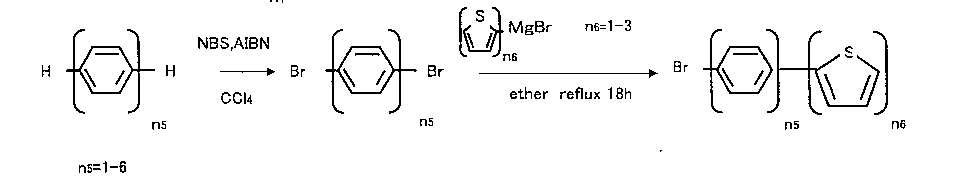

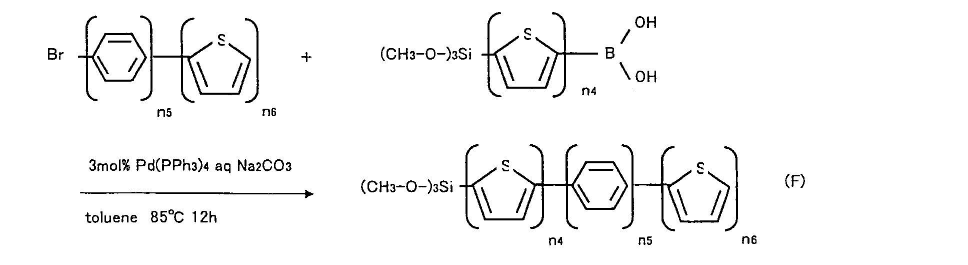

As a method of synthesizing a precursor in which a benzene or thiophene-derived unit and a vinyl group are alternately bound, for example, the following method can be applied. That is, after a raw material having methyl group at a reactive site of benzene or thiophene is prepared, its both terminuses are brominated using 2,2'-azobisisobutyronitrile (AIBN) and N-bromosuccinimide (NBS). Thereafter, the bromo entity is reacted with PO(OEt)₃ to form an intermediate. Subsequently, a compound having an aldehyde group at a terminus and the intermediate are reacted using NaH, for example, in DMF solvent, thereby, the precursor can be formed. Since the resulting precursor has methyl group at a terminus, for example, when this methyl group is further brominated, and the above synthesis route is applied again, a precursor having a further greater number of units can be formed.

When the resulting precursor is brominated, for example, using NBS, it becomes possible to react the brominated part and SiCl₄. Whereby, a silicon compound having SiCl₃ at a terminus can be formed. One example of a route for synthesizing precursors (G) to (I) having different lengths, and a silicon compound (J) using such the reaction is shown below.

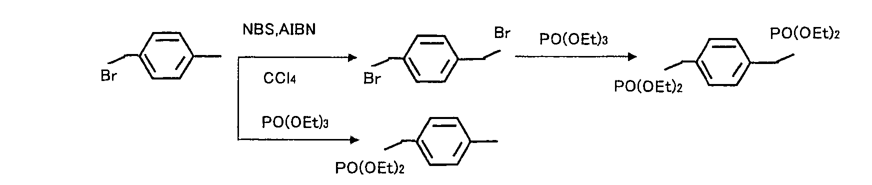

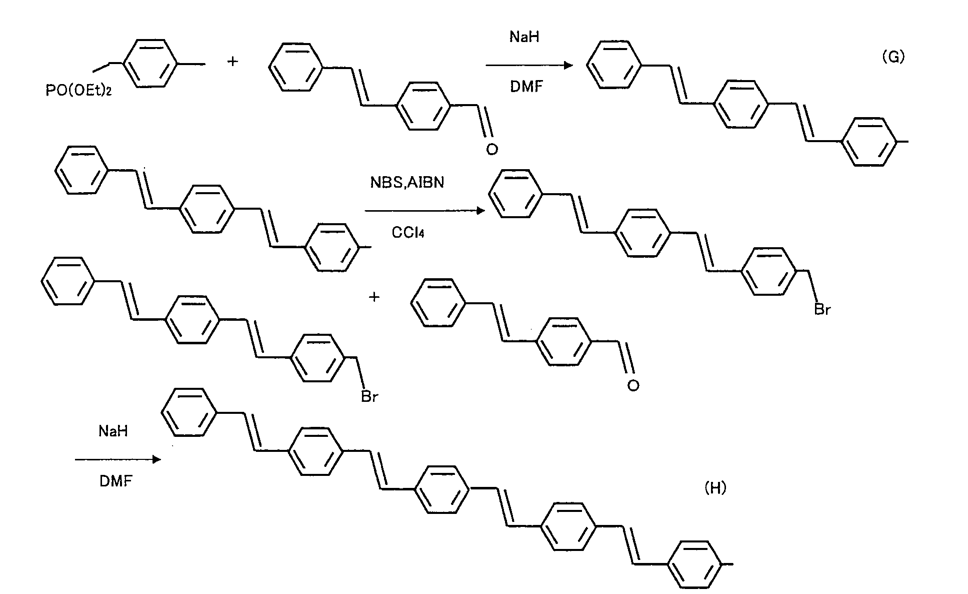

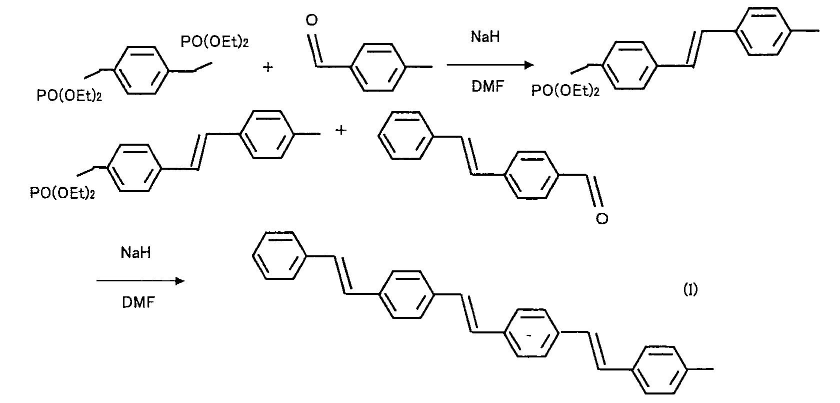

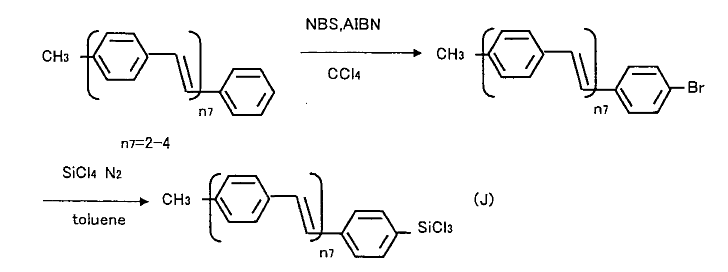

Regarding any compound, a raw material having a side chain (e.g. alkyl group) at a prescribed position can be used. That is, for example, when 2-octadecylterthiophene is used as a raw material, 2-octadecylsexithiophene as a precursor (A) can be obtained by the above synthesis route. Therefore, as Silicon compound (C), 2-octadecylsexithiophenetrichlorosilane can be obtained. Similarly, when a raw material having a side chain at a prescribed position in advance is used, a compound which is any compound of (A) to (J) and has a side chain can be obtained.

Raw materials used in the above synthesis example are general-use reagents, and can be obtained from reagent makers, and can be utilized. A CAS number of a raw material, and purity of a reagent when obtained from Kishida Chemicals (Japan) as a reagent maker are shown below.

**Table 1**

| raw material | CAS number | purity |
|---|---|---|
| 2-chlorothiophene | 96-43-5 | 98% |
| 2,2',5',2"-terthiophene | 1081-34-1 | 99% |
| bromobenzene | 108-86-1 | 98% |
| 1,4-dibromobenzene | 106-37-6 | 97% |
| 4-bromobiphenyl | 92-66-0 | 99% |
| 4,4'-dibromobiphenyl | 92-86-4 | 99% |
| p-terphenyl | 92-94-4 | 99% |
| α-bromo-p-xylene | 104-81-4 | 98% |

Silicon compounds as obtained can be isolated and purified from a reaction solution by the known means such as transfer dissolution, concentration, solvent extraction, fractionation, crystallization, recrystallization and chromatography. This Silicon compound can be formulated into a film, for example, as described later.

Then, in the present invention, a functional organic thin film derived from the above Silicon compound (hereinafter, simply also referred to as organic thin film) formed on a substrate is provided.

The organic thin film of the present invention is formed on a substrate. Herein, the substrate can be appropriately selected depending on utility of an organic thin film. Examples include substrates comprising materials such as semiconductors such as element semiconductors such as silicon and germanium, and compound semiconductors such as GaAs, InGaAs and ZnSe; glass, quartz glass; insulating polymer films such as polyimide, PET, PEN, PES and Teflon (registered trade mark); stainless steel (SUS); metals such as gold, platinum, silver, copper and aluminum; high melting point metals such as titanium, tantalum and tungsten; silicide and polycide with high melting point metals; insulating materials such as silicon oxide (hot silicon oxide, low temperature silicon oxide: LTO and the like, high temperature silicon oxide, silicon nitride, SOG, PSG, BSG and BPSG; PZT, PLZT, ferroelectrics, and antiferroelectrics; low dielectric materials such as SiOF-based material, SiOC-based material or CF-based material, or HSQ (hydrogen silsesquioxane)-based material (inorganic-based) formed by coating, MSQ (methyl silsesquioxane)-based material, PAE (polyarylene ether)-based material, BCB-based material, porous-based material, or CF-based material, or porous materials. Further, so-called SOI substrate, multilayered SOI substrate and SOS substrate can be also used. These substrates may be used alone, or a plurality of them may be laminated.

Inter alia, it is preferable to use the substrate in which active hydrogen such as hydroxyl group and carboxyl group can be protruded on a surface, or the substrate in which active hydrogen can be protruded by hydrophilization treatment. Hydrophilization treatment can be performed, for example, by immersing the substrate in a mixed solution of hydrogen peroxide and concentrated sulfuric acid.

On a surface of the substrate, a film is formed using a silicon compound represented by the formula: R-SiX¹X²X³ (I). Consequently, a terminus of this compound is converted into an oxy group, preferably a -Si-O- group and, by binding to the substrate surface in which active hydrogen is protruded by hydrophilization-treating the surface, it can be arranged in a film manner. In addition, silicon in a compound of the formula (I) can be usually bound to silicon in an adjacent compound of the formula (I) via an oxy group.

This silicon compound of the formula (I) can be made into a thin film, for example, by a chemical adsorption method as follows.

First, Silicon compound of the formula (I) is dissolved in a non-aqueous organic solvent such as hexane, chloroform, carbon tetrachloride and n-hexadecane. When a substituent X¹, X² and/or X³ is an alkoxy group in the formula (I), a solution which is not non-aqueous may be used, for example, for a procedure of promoting a reaction such as hydrolysis.

A concentration of Silicon compound in the solution is not particularly limited, but for example, is suitably about 1mM to 100nM. In the resulting solution, the substrate (preferably the substrate having active hydrogen such as a hydroxyl group and carboxyl group) on which a thin film is to be formed is immersed and pulled up. Alternatively, the resulting solution may be coated on a substrate surface. Thereafter, a thin film can be fixed by washing with a non-aqueous organic solvent, and drying by allowing to stand or heating. This thin film can be used as it is as an organic thin film, or may be used after it is subjected to treatment such as electrolytic polymerization.

The thin film formed as described above may be a monomolecular film, or an accumulated monomolecular film in which those thin films are piled.

The accumulated monomolecular film can be made.

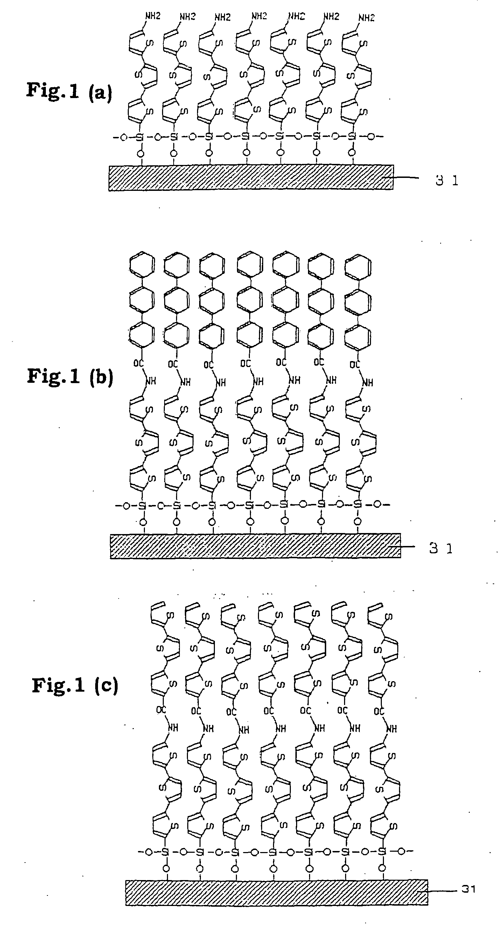

First, as shown in Fig. 1 (a), a monomolecular film of Silicon compound having a functional group (e.g. amino group etc.) at a terminus is formed on a substrate 31, for example, by a chemical adsorption method. The resulting substrate 31 is immersed in a solvent containing, for example, a compound having a functional group (e.g. carboxyl group etc.) reactive with a functional group at a terminus (e.g. compound of formula (8)) for a definite time, to react them, thereby, the accumulated monomolecular film having no binding with an adjacent molecule can be formed without changing a structure of a first layer of a monomolecular film, as shown in Fig.1 (b).

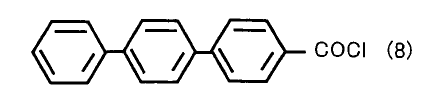

A method of preparing an accumulated monomolecular film is not limited to the above method, but any procedure may be used as far as it is a general procedure which can perform lamination. Examples of the general procedure include, in addition to the aforementioned procedure, a procedure of changing a terminus of a monomolecular film as a first layer prepared in advance into a functional group reactive with a compound to be laminated, by electrolytic polymerization or catalytic reaction and, thereafter, reacting this with a compound to be laminated.

Also, a monomolecular film to be laminated at a second layer or later can be made, for example, using a compound represented by the formula: K²-R'-K³ (IV). Examples of a functional group in K² and K³ in the formula include hydroxyl group, a substituted or unsubstituted amino group, nitro group, cyano group, a substituted or unsubstituted alkyl group, a substituted or unsubstituted alkenyl group, a substituted or unsubstituted cycloalkyl group, a substituted or unsubstituted alkoxy group, a substituted or unsubstituted aromatic hydrocarbyl group, a substituted or unsubstituted aromatic heterocycle group, a substituted or unsubstituted aralkyl group, a substituted or unsubstituted aryloxy group, a substituted or unsubstituted alkoxycarbonyl group, carboxyl group and an ester group. Among these functional groups, a functional group which does not inhibit crystallization of an organic thin film due to steric hindrance is preferable. Therefore, among the above functional groups, a linear alkyl group having a carbon number of 1 to 30 is particularly preferable. When an accumulated film is prepared, a functional group is preferably a functional group which can be bound with a compound to be laminated at a second layer or later, and is preferably positioned at a terminus of an organic residue. Examples of such the functional group include amino group, carboxyl group, acyl group, formyl group, carbonyl group, nitro group, nitroso group, azido group, an acid azido group and an acid chloride group.

Specifically, the film can be made using, for example, a compound represented by the formula:

R-SiX⁴X⁵X⁶ (V)

wherein, R is as defined above, one of X⁴ to X⁶ is a group affording hydroxyl group by hydrolysis, and the other two are each a functional group not reactive with an adjacent molecule. In the formula, examples of the group affording a hydroxyl group by hydrolysis of X⁴ to X⁶ include groups represented by X¹ to X³. Examples of the functional group not reactive with an adjacent molecule include an alkyl group.

Such the compound may be the aforementioned compound of the formula (8) without limiting thereto, and may be a compound which contains a π -electron conjugating unit and has a functional group reactive with a monomolecular film as a first layer.

Also, the thickness of a monomolecular film can be appropriately adjusted by the number of bound organic residues, and is for example around 1nm to 12nm, and is preferably around 1nm to 3.5nm taking economical property and mass production into consideration. Letting a thickness of a monomolecular film to be "c", and letting an accumulation number to be "d", a film thickness in the case of an accumulated film of a monomolecular film is approximately "c×d". When a film in which every monomolecular film has different function is prepared, a molecular structure and a film thickness of a monomolecular film are made to be different depending on its function in some cases, and a film thickness of a monomolecular accumulated film in that case can be appropriately adjusted depending on necessity.

Like this, by forming a thin film, such as a monomolecular film or an accumulated monomolecular film, Silicon compound of the formula (I) is easily self-organized, while its constitutional units are oriented in a constant direction. That is, by minimizing a distance between adjacent units, a highly crystallized organic thin film can be obtained, consequently showing electric conductivity in a direction orthogonal with a substrate surface.

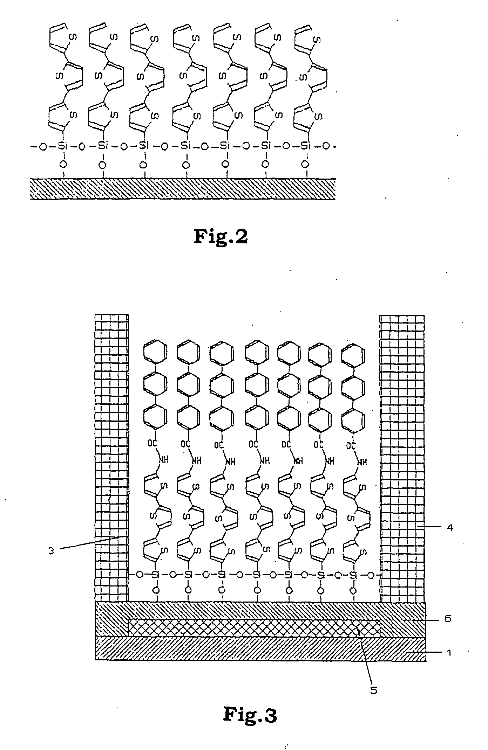

In addition, when adjacent silicon atoms in the formula (I) are crosslinked as they are or via oxygen atom, a film is short at a distance between adjacent units and is more highly crystallized, for example under the Si-O-Si network. In particular, when units are arranged in a straight manner, as shown in Fig.2, adjacent units are not bound, and a distance between adjacent units is minimized, thereby providing a highly crystallized material. By such the orientation of units, an organic thin film exhibiting semiconductor property in a direction of a substrate surface can be obtained.

Like this, it is possible to obtain a thin film having electric anisotropy in which electric property in a vertical direction and a surface direction relative to a substrate surface is different.

Further, when an organic thin film is an accumulated monomolecular film, as shown in Fig.3, by accumulating films having different functions, it becomes possible to separate different functions into each part of a film in the same film.

The organic thin film of the present invention can be used as an electric conductive material constituting an organic thin film transistor such as TFT, a light emitting element, a solar cell, a fuel cell, or a sensor, or as a thin film constituting a photoconductive material (photoconductor), or a non-linear optical material, by selecting a unit (particularly, the presence or the absence of hetero atom) and a kind of a functional group (electron withdrawing-type or electron donor-type group). In addition, the organic thin film can be also used as a biosensor since an enzyme as a ligand can be bound by a functional group at a terminus. Specific examples of application of the organic thin film of the present invention will be described below.
· Semiconductor layers (region between source and drain) of TFT
· Films between electrodes (light emitting layer, electron injecting layer, hole injecting layer etc.) of organic EL and organic phosphorescence emitting elements
· Films between electrodes of organic semiconductor lasers (e.g. current injection-type layer such as diode) (light can be emitted by recombining holes and electrons injected from each electrode on an organic thin film, and the resulting light can be taken out from a constant direction)
· p-type and n-type materials of solar cell (since an organic thin film has optical excitation property, when p-type and n-type materials as a thin film are piled, a p-n junction can be formed, and a solar cell can be formed)
· Separators of fuel cells
· Films for adsorbing a gas molecule in a gas sensor or an odor component in an odor sensor (when an organic thin film is arranged on a comb-type electrode, a gas sensor for assessing a concentration of an air molecule by change in electric conductivity of an organic thin film due to adsorption of an air molecule can be formed)
· Ion sensitive films of ion sensors
· Sensitive films of biosensors (e.g. immunosensor) (utilizing selectivity of enzyme of organic thin film)

According to the present invention, an organic thin film transistor having the aforementioned organic thin film as an essential element is provided.

The organic thin film transistor of the present invention is composed mainly of a substrate, an organic thin film, a gate insulating film, a gate electrode and source/drain electrodes. The transistor can take various forms such as a staggered type, a reverse staggered type and a variation thereof. For example, in the case of a staggered type, examples include a form in which an organic thin film is formed on a substrate, a gate electrode is arranged thereon via a gate insulating film, and source/drain electrodes which are separated from a gate electrode, are on both sides of the gate electrode and are in contact with an organic thin film. In addition, in the case of a reverse staggered type, a form in which a gate electrode is formed on a substrate, an organic thin film is formed on a gate electrode via a gate insulating film, and source/drain electrodes in contact with an organic thin film are arranged on an organic thin film so that they are not overlapped with a gate electrode may be used.

The substrate can be appropriately selected depending on the kind of the organic thin films, and construction and performance of a transistor. Examples include substrates comprising materials such as semiconductors such as element semiconductors such as silicon and germanium, and compound semiconductors such as GaAs, InGaAs and ZnSe; glass, quartz glass; insulating polymer films such as polyimide, PET, PEN, PES and Teflon (registered trade mark), stainless steel (SUS); metals such as gold, platinum, silver, cupper and aluminum; high melting point metals such as titanium, tantalum and tungsten; silicide or polycide with high melting point metals. Further, so-called SOI substrate, multilayered SOI substrate and SOS substrate can be also used. These substrates may be used alone, or a plurality of them may be laminated. In particular, when the organic thin film is directly formed on a substrate, a substrate in which active hydrogen such as hydroxyl group and carboxyl group can be protruded on a substrate by hydrophilization treatment is preferable. Hydrophilization treatment can be performed, for example, by immersing in a mixed solution of hydrogen peroxide and concentrated sulfuric acid.

The organic thin film is a film obtained by forming a monomolecular film or an accumulated monomolecular film in which monomolecular films are piled, using the aforementioned Silicon compound. In particular, Silicon compound may be directly bound to the substrate or a gate insulating film, and is preferably bound to it by a siloxane bond (-Si-O-). In addition, it is preferable that units which are adjacent in a substrate surface direction are not bounded and, further, a plurality of units in Silicon compound is bound in a straight manner.

Examples of the gate insulating film usually include an insulating film used in a transistor. Examples include insulating films such as silicon oxide film (thermal oxidized film, low temperature oxidized film:
LTO film, high temperature oxidized film: HTO film), silicon nitride film, SOG film, PSG film, BSG film and BPSG film; PZT, PLZT, ferroelectric or antiferroelectric film; low dielectric film such as SiOF-based film,
SiOC-based film or CF-based film, HSQ (hydrogen silsesquioxane)-based film (inorganic-based), MSQ (methyl silsesquioxane)-based film, PAE (polyalylene ether)-based film, BCB-based film, porous-based film or CF-based film formed by coating, or porous films. The film thickness is not particularly limited, but usually can be appropriately adjusted to a film thickness used in a transistor.

The gate electrode and source / drain electrodes can be usually formed with an electric conductive material used in a transistor. Examples of the electric conductive material include a monolayer and a laminated layer of metals such as gold, platinum, silver, cupper and aluminum; high melting point metals such as titanium, tantrum and tungsten; silicide and polycide with high melting point metals. A film thickness is not particularly limited, but usually can be appropriately adjusted to a film thickness used in a transistor.

The organic thin film transistor of the present invention can be applied to a variety of utilities, as semiconductor devices such as a memory, a logic element and a logic circuit, in electronic devices: e.g., data processing systems such as computer systems of personal computer, notebook, laptop, personal·assistant/transmitter, minicomputer, work station, main frame, multiprocessor·computer and other all types; electron parts constituting data processing systems such as CPU, memory and data memory device; communication equipments such as telephone, PHS, modem and router; image display equipments such as display panel and projector; office work equipments such as printer, scanner and copying machine; sensor; image pickup equipments such as video camera and digital camera; leisure equipments such as gaming machine and music player; information equipments such as portable information terminal, clock and electronic dictionary; car packaging equipments such as car navigation system and car audio; AV equipments for recording and reproducing information such as animation, still picture and music; electric appliances such as washing machine, microwave oven, refrigerator, rice cooker, dish washer, vacuum cleaner and air conditioner; health managing equipments such as massage equipment, scales and tonometer; portable-memory devices such as IC card and memory card.

Examples of the organic thin film of the present invention and a process for preparing the same will be explained below.

### Example 1: Synthesis of terphenyltrichlorosilane by Grignard method

In a 500 ml glass flask equipped with a stirrer, a reflux condenser, a thermometer and a dropping funnel, 1.5 mole of terphenyl was dissolved in carbon tetrachloride, to which NBS and AIBN were added. The mixture was stirred for 3 hours, and filtered under reduced pressure to obtain bromoterphenyl. Subsequently, in a 500 ml glass flask equipped with a stirrer, a reflux condenser, a thermometer and a dropping funnel, 0.5 mole of metal magnesium and 300 ml of THF (tetrahydrofuran) were put, to which 0.5 mole of the bromoterphenyl was dropwise added at 50 to 60°C over 2 hours using dropping funnel. After the dropping having been completed, the mixture was aged at 65°C for 2 hours to prepare Grignard reagent.

In a 1 liter glass flask equipped with a stirrer, a reflux condenser, a thermometer and a dropping funnel, 1.0 mole of SiCl₄ (tetrachlorosilane) and 300 ml of toluene were put and cooled with ice, to which the Grignard reagent was dropwise added at an internal temperature of 20°C or lower over 2 hours. After the dropping having been completed, the mixture was aged at 30°C for an hour (Grignard reaction).

Then, the reaction solution was filtered under reduced pressure to remove magnesium chloride. Toluene and unreacted tetrachlorosilane were stripped from the filtrate, and the resulting solution was distilled to obtain the title compound at a yield of 50%.

The resulting compound was confirmed to contain SiC bond, by its infrared absorption spectrum which showed the absorption derived from SiC at 1080 cm⁻¹.

Separately, an ultraviolet-visible absorption spectrum of a solution containing the resulting compound was measured, and observed the absorption at a wavelength of 280 nm. This absorption is due to π→π *transition of terphenyl molecule contained in the molecule, and hence it was confirmed that the compound contains terphenyl molecule.

Further, nuclear magnetic resonance (NMR) of the compound was measured. Since it is impossible to directly measure NMR of the resulting compound due to high reactivity of the compound, the compound was reacted with ethanol (generation of hydrogen chloride was confirmed) for converting terminal chlorine atom into ethoxy group and then was measured.
7.95 ppm to 7.35 ppm (m) (13H aromatic-derived)
2.60 ppm (m) (3H ethoxy group-derived)

From these results, it was confirmed that the resulting compound is terphenyltrichlorosilane represented by the formula (1)

### Example 2: Synthesis of terthiophenetrichlorosilane by Grignard method

In a 500ml glass flask equipped with a stirrer, a reflux condenser, a thermometer and a dropping funnel, 1.0 mole of terthiophene was dissolved in carbon tetrachloride, to which NBS and AIBN were added. The mixture was stirred for 2.5 hours, and filtered under reduced pressure to obtain bromoterthiophene. Subsequently, in a 500 ml glass flask equipped with a stirrer, a reflux condenser, a thermometer and a dropping funnel, 0.5 mole of metal magnesium and 300 ml of THF (tetrahydrofuran) were charged, to which 0.5 mole of bromoterthiophene was dropwise added at 50 to 60°C over 2 hours using a dropping funnel. After the dropping having been completed, the mixture was aged at 65°C for 2 hours to prepare Grignard reagent.

In a 1 liter glass flask equipped with a stirrer, a reflux condenser, a thermometer and a dropping funnel, 1.5 mole of SiCl₄ (tetrachlorosilane) and 300 ml of toluene were charged and cooled with ice. The Grignard reagent was dropwise added at an internal temperature of 20°C or lower over 2 hours. Thereafter, the mixture was aged at 30°C for an hour (Grignard reaction).

Then, the reaction solution was filtered under reduced pressure to remove magnesium chloride. Toluene and unreacted tetrachlorosilane were stripped from the filtrate. The solution was distilled to obtain the title compound at a yield of 55%.

The resulting compound was confirmed to contain SiC bond by an infrared absorption spectrum, which showed the absorption derived from SiC at 1060 cm⁻¹.

In addition, an ultraviolet-visible absorption spectrum of a solution containing the compound showed the absorption at a wavelength of 360 nm, due to π → π* transition of a terthiophene molecule contained in a molecule. Thus, it was confirmed that the compound contains terthiophene molecule.

Further, since it is impossible to directly measure NMR of this compound due to high reactivity of the compound, the compound was reacted with ethanol (generation of hydrogen chloride was confirmed), for converting terminal chlorine into ethoxy group and measured for its NMR.
7.50 ppm to 7.00 ppm (m) (7H thiophene ring-derived)
2.20 ppm (m) (3H ethoxy group-derived)

From these results, it was confirmed that this compound is terthiophenetrichlorosilane represented by the formula (2).

### Example 3: Synthesis of terthiophenetrichlorosilane utilizing Li

In one liter glass flask equipped with a stirrer, a thermometer and a dropping funnel, 300 ml of a tetrahydrofuran solution containing 1.0 mole of terthiophene was charged and cooled to -78°C, to which 1.0 mole of n-butyllithium was slowly and dropwise added. Then the mixture was stirred for an hour to yield a lithium salt of terthiophene having the structure represented by the formula (a).

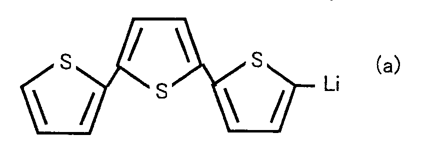

Then, a solution of tetrachlorosilane in tetrahydrofuran was added to the above mixture and was stirred overnight. Lithium chloride, toluene and unreacted tetrachlorosilane were removed from the reaction solution. Thereafter, this solution was distilled to obtain the title compound at a yield of 45%.

Regarding the resulting compound, its infrared absorption spectrum and nuclear magnetic resonance were measured, and show the absorptions at the same positions as that of the compound shown in Example 2. Thus, it was confirmed that this compound is terthiophenetrichlorosilane represented by the formula (2) prepared in Example 2.

### Example 4: Preparation of an organic thin film and measurement of its semiconductor property

A toluene solution containing the π -electron coupled molecule-containing silicon compound obtained in Example 2 was prepared. A silicon substrate in which hydroxy group had been protruded on a surface by hydrophilization treatment in advance was immersed in the toluene solution to make an organic thin film.

Since terthiophene absorption was seen at a wavelength of 360 nm in an ultraviolet-visible absorption spectrum, it was confirmed that Silicon compound was adsorbed onto a substrate surface.

In addition, in X-ray diffraction, a peak was confirmed at 2θ=22.7°, and it was seen that a crystalline film having an interplanar spacing of 0.392 nm was formed. This predicts that since terthiophenetrichlorosilane of the present invention is chemically adsorbed onto the substrate by formation of a two-dimensional network of Si-O-Si formed between silicon compounds and, at the same time, intermolecular interaction exerting on π -electron conjugated molecules which is a near distance force necessary for crystallization of a film effectively exerts, the terthiophenetrichlorosilane constitutes an organic thin film which has very high stability and is highly crystallized.

As a result, it was shown that the compound of the present invention can be utilized as an organic thin film forming material having high crystallizability.

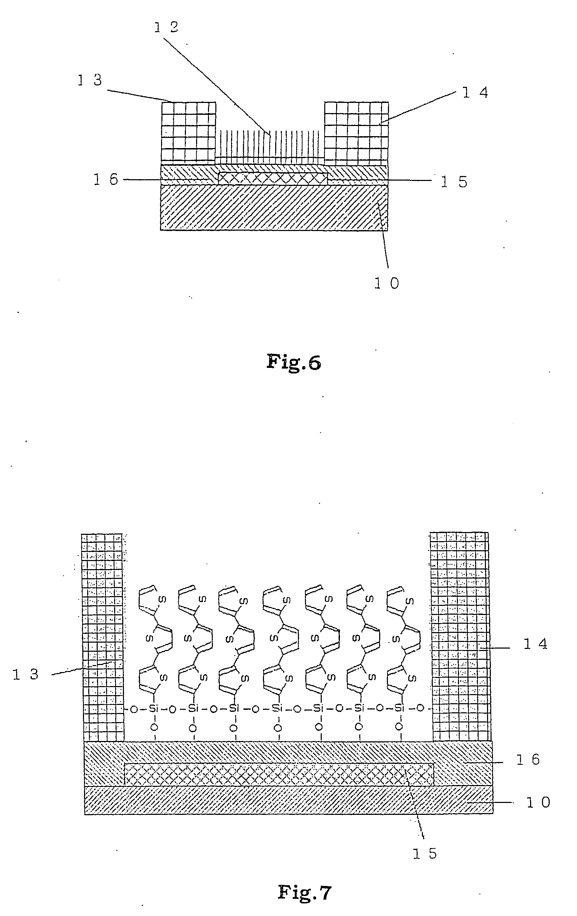

In addition, in order to investigate semiconductor property possessed by the prepared organic thin film, as shown in Fig. 5, an organic thin film 23 provided with a blocking electrode 21 and a counter electrode 22 on both sides thereof was prepared. In this system, when a light pulse is applied to a blocking electrode from a direction shown by an arrow in the state where a voltage is applied between an electrode 21-electrode 22, a carrier is generated on an electrode 21 side, and subsequently moved to an electrode 22. When this is detected with a detector 24, a mobility can be assessed from a moving time of a carrier, and a distribution state of a carrier (transient photocurrent measuring method). A mobility of terthiophenetrichlorosilane organic thin film was measured using this measuring method and, as a result, it was 1×10⁻¹ cm²/Vs.

From this result, it was shown that the compound of the present invention can be utilized as a material having semiconductor property. In addition, also regarding the aforementioned compounds of (1) to (7), then mobility was similarly measured, and it was confirmed that they have similar semiconductor property.

### Example 5: Measurement of electric conductivity of an organic thin film with terthiophenetrichlorosilane (direction vertical to substrate)

A silicon substrate to which electrical conductivity (0.1 to 0.2 Ω·cm) had been imparted by high doping was subjected to hydrophilic treatment, by immersing in a mixed solution of hydrogen peroxide and concentrated sulfuric acid (mixing ratio 3:7) for an hour. Thereafter, under an inert atmosphere, the resulting substrate was immersed for 5 minutes in a 10 mM terthiophenetrichlorosilane solution in a non-aqueous solvent (e.g. n-hexadecane), slowly pulled up and washed with a solvent to form a film on a substrate.

Regarding the resulting organic thin film, electric conductivity in a film thickness direction of an organic thin film (direction vertical to substrate) was measured using SPM (scanning type probe microscope) and, as a result, a high value of 10⁻⁴ S/cm or greater was obtained.

This can predict that electric conductivity in a direction of an axis of a molecule constituting an organic thin film is obtained.

### Example 6: Measurement of electric conductivity of an organic thin film with quarterthiophenetrichlorosilane (direction parallel with substrate)

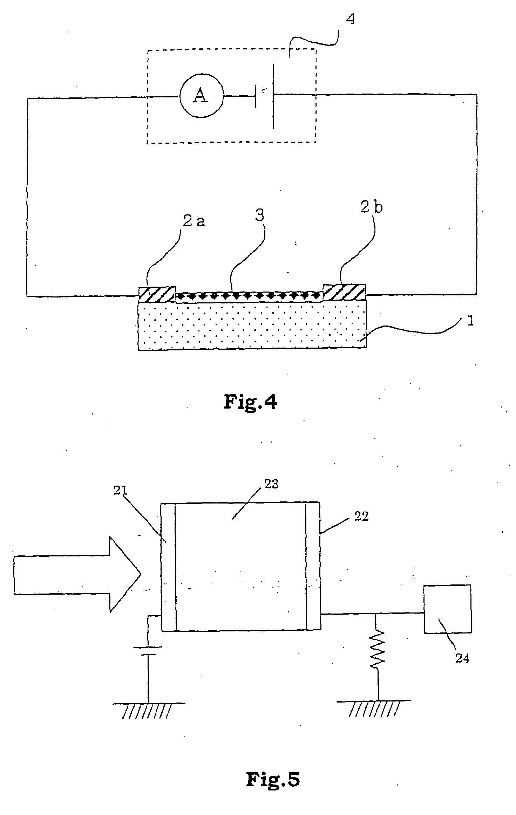

As shown in Fig. 4, electrode terminals 2a,2b were prepared on a quartz substrate 1 by Au deposition. Thereafter, a direct current source for applying a prescribed voltage between both terminals 2a,2b, and an ammeter electric conductivity measuring means 4 for detecting a current between both terminals 2a,2b were provided, and electric conductivity of an organic thin film 3 was measured.

As a result of measurement of electric conductivity at the thus prepared electrode terminals, a value of 10⁻⁵ to 10⁻⁷ S / cm was shown.

As a result of measurement of a mobility by the same method as that of Example 4, that is, a transient photocurrent measuring method, a mobility of quarterthiophenetrichlorosilane organic thin film was 1×10⁻¹ cm²/Vs.

From these results, it was made clear that this organic thin film has excellent electric conductivity in a direction vertical to a substrate, and has excellent semiconductor property in a planar direction, that is, anisotropy as electric property in a vertical direction and a planar direction.

### Example 7: Formation of an organic thin film with terphenyltrichlorosilane

Using terphenyltrichlorosilane of Example 1, an organic thin film was formed.

First, quarts substrate was subjected to hydrophilic treatment by immersing in a mixed solution of hydrogen peroxide and concentrated sulfuric acid (mixing ratio 3:7) for an hour. Thereafter, under an inert atmosphere, the resulting substrate was immersed for 5 minutes in a 10 mM terphenyltrichlorosilane solution in a non-aqueous solvent (e.g. n-hexadecane), slowly pulled up and washed with a solvent to form a film on the quartz substrate.

The quartz substrate on which the film was formed was measured with a ultraviolet visible absorption spectrophotometer, and 272 nm due to an absorption wavelength of terphenyl which is a π -electron coupled molecule was detected. In addition, from measurement of a film thickness by ellipsometry, the result of 1.4 nm corresponding to a molecular length was obtained. From this, it was confirmed that a monomolecular film containing a group derived from π -electron coupled terphenyl was formed on the quartz substrate.

### Example 8: Formation of an organic thin film with terthiophenetrichlorosilane

An organic thin film was formed using terthiophenetrichlorosilane of Example 2.

As in Example 7, under an inert atmosphere, a hydrophilization-treated quartz substrate was immersed for 5 minutes in a 10mM terthiophenetrichlorosilane solution in which terthiophenetrichlorosilane was dissolved in a non-aqueous solvent (e.g. n-hexadecane), slowly pulled up and washed with a solvent to form a film on a quartz substrate.

The quartz substrate on which the film was formed was measured with a ultraviolet visible absorption spectrophotometer, and 357 nm due to an absorption wavelength of terthiophene which is a π -electron coupled molecule was detected. In addition, from measurement of a film thickness by ellipsometry, the result of 1.2 nm corresponding to a molecular length was obtained. From this, a monomolecular film containing a group derived from terthiophene which is a π -electron coupled molecule was confirmed on the quartz substrate.

### Example 9: Formation of an organic thin film with quarlerphenyl lrichlorosilane

A Si substrate having an oxidized film (Si0₂) on a surface was immersed for an hour in a mixed solution of hydrogen peroxide and concentrated sulfuric acid (mixing ratio 3:7) to hydl-ophilization-treat a quartz substrate surface.

Thereafter, under an inert atmosphere, this was immersed for 5 minutes in a 5mM quarterphenyltrichlorosilane solution in which quarterphenyltrichlolosilane was dissolved in a non-aqueous solvent (e.g. toluene), slowly pulled up and washed with a solvent to form a monomolecular film on the Si substrate.

The Si substrate on which the monomolecular film was formed was measured with a X-ray diffraction apparatus, and a clear diffraction peak due to a crystal was confirmed. Calculation was tried from a detective diffraction angle, and this corresponds to an interplanar spacing: 0.456 nm. From this, it was seen that a monomolecular film having high crystallizability is formed.

### Example 10: Formation of accumulating functional film by lamination of aminoterthiophenetrichlorosilane

First, aminoterthiophenetrichlorosilane which is a compound of the formula (2') was prepared by Grignard method as in Example 2.

Using the thus prepared aminoterthiophenetrichlorosilane, an organic thin film was formed.

As in Example 7, under an inert atmosphere, a hydrophilization-treated quartz substrate was immersed for 5 minutes in a 10mM aminoterthiophenetrichlorosilane solution in which aminoterthiophenetrichlorosilane was dissolved in a non-aqueous solvent (e.g. n-hexadecane), slowly pulled up and washed with a solvent to form a monomolecular film on the quartz substrate as shown in Fig. 1 (a). The resulting monomolecular film was confirmed to have a peak at 2θ=22.7° in X-ray diffraction, and had crystallizability with an interplanar spacing of 0.39 nm. This monomolecular film had approximately same crystallizability as that of a monomolecular film containing terthiophene. In addition, in infrared measurement of the monomolecular film, absorption derived from an amino group was confirmed at a wavelength of 3500 to 3300 cm⁻¹. From this, it was confirmed that the monomolecular film has an amino group.

Subsequently, a toluene solution containing 10mM of a terthiophene derivative which is the following compound: 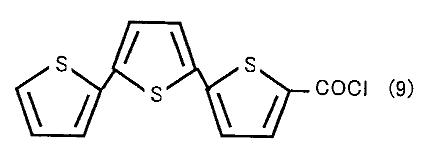 was prepared, and the monomolecular film was immersed in the solution for an hour. Then, the monomolecular film was slowly pulled up, and washed with a solvent to form a second monomolecular film on a first monomolecular film, to prepare an accumulated film shown in Fig. 1 (c).

Regarding the resulting accumulated film, from measurement of a film thickness by ellipsometry, the result of 2.6 nm corresponding to a molecular length was obtained. In addition, in infrared measurement of the monomolecular film, absorption derived from an amido group was confirmed at a wavelength of 3200 cm⁻¹. Thereby, it was confirmed that the accumulated film having a structure in which monomolecular films containing a group derived from terthiophene which is a π -electron coupled molecule are laminated via an amido bond is formed on the quartz substrate.

In this Example, an example of a thin film in which terthiophenetrichlorosilane films were amido-bonded was shown, but any bond species may be used as far as first and second monomolecular films are chemically bound. In addition, regarding a compound species to be laminated, herein, a group derived from terthiophene which is one of organic residues comprising a π -electron coupled unit was explained, but a group other than a group derived from terthiophene may be used as far as it is an organic residue comprising a π -electron coupled unit.

### Comparative Example 1: Formation of film with biphenyltrichlorosilane

Under an inert atmosphere, a Si substrate which had hydrophilization-treated as in Example 9 was immersed for 5 minutes in a 5mM biphenyltrichlorosilane solution in which biphenyltrichlorosilane had been dissolved in a non-aqueous solvent (e.g. n-hexadecane), slowly pulled up, and washed with a solvent to form a monomolecular film on a Si substrate.

The resulting Si substrate on which the monomolecular film was formed was measured with a X-ray diffraction apparatus, and a clear diffraction peak due to a crystal could not be confirmed. From this, it was made clear that the monomolecular film containing biphenyl which is a dimer of benzene had no crystallizability.

### Example 11

### Preparation of organic thin film transistor

In order to prepare an organic thin film transistor shown in Fig. 6, first, chromium was deposited on a silicon substrate 10 to form a gate electrode 15.

Then, an insulating film 16 of a silicon nitride film was deposited by a plasma CVD method, followed by depositing chromium and gold successively. A source electrode 13 and a drain electrode 14 were formed by the conventional lithography technique.

Subsequently, the resulting substrate was immersed for an hour in a mixed solution of hydrogen peroxide and concentrated sulfuric acid (mixing ratio 3:7) to hydrophilization-treat a surface of the insulating film 16. Thereafter, under anaerobic condition, the resulting substrate was immersed for 5 minutes in a 20mM terthiophenetrichlorosilane solution in which terthiophenetrichlorosilane obtained above was dissolved in a non-aqueous solvent (e.g. n-hexadecane), slowly pulled up and washed with a solvent to form an organic semiconductor layer 12.

Regarding the resulting organic semiconductor layer 12, since terthiophene absorption was seen at a wavelength of 360 nm in a ultraviolet-visible absorption spectrum, it was confirmed that Silicon compound was adsorbed onto the substrate (insulating film) surface. In addition, from measurement of a film thickness by ellipsometry, the result of 1.2 nm corresponding to a molecular length was obtained. Further, in X-ray diffraction, a peak was confirmed at 2θ=22.7°, and it was seen that a crystallizable film having an interplanar spacing of 0.392 nm is formed. Therefore, it can be said that in this crystallizable film, for example, as shown in Fig. 7, adjacent terthiophene molecules are regularly formed. That is, a π -electron conjugated unit is bound to a surface of the insulating film 16 via a siloxane bond, but adjacent silicon compounds are not bounded. That is, as shown in Example 4, it is proper to presume that adjacent terthiophene molecules could form a crystallizable film having high ordering property by mutual intermolecular interaction.

Thereby, a film having high electric conductivity in a direction of binding of units can be obtained and, when a voltage is applied to the resulting organic thin film transistor from an outside, electron or hole transportation by electron flying between adjacent molecules, so-called hopping conduction is performed between molecules which are not bound to an adjacent molecule, and it becomes possible to increase an on current. That is, when on, since adjacent molecules are shorter by interaction between induced dipoles, the atmosphere in which hopping conduction is easily caused is obtained, and an on current can be increased. In addition, since there is no binding between adjacent organic molecules, a leaked current when no external voltage is applied is not generated.

In addition, since there is no binding between π -electron coupled molecules (between adjacent molecules) bound to Si contained in a two-dimensional network of Si-O-Si, it is possible to decrease a leaked current at off.

In the organic thin film transistor obtained above, a field-effect mobility was 1×10⁻¹ cm²/Vs, an on/off ratio was about 6 order, and better performance could not be obtained.

From the above Example, since a monomolecular film formed using a compound having a π -electron coupled unit, and having a silanol group having a functional group reactive with a moisture, for example, by a chemical adsorption method forms a two-dimensional network of Si-O-Si, a highly self-organized film can be formed.

### Example 12

Preparation of an organic transistor using, as an organic thin film, an accumulated functional film by lamination of terthiophenetrichlorosilane will be explained in line with the drawing.

First, aminoterthiophenetrichlorosilane which is a compound of the (2') was prepared by Grignard method as in a process for preparing terthiophenetrichlorosilane.

Using the thus prepared aminoterthiophenetrichlorosilane, a functional thin film was formed.

Subsequently, a substrate obtained by hydrophilization-treating a substrate obtained by successively forming a gate electrode, an insulating film, and source/drain electrodes on a silicon substrate as in Example 11 was immersed for 5 minutes in a 10mM aminoterthiophenetrichlorosilane solution in which aminoterthiophenetrichlorosilane was dissolved in a non-aqueous solvent (e.g. n-hexadecane), under an inert atmosphere, slowly pulled up and washed with a solvent to form a monomolecular film on the substrate as shown in Fig. 1 (a). In the resulting monomolecular film, a peak was confirmed at 2θ=22.7° in X-ray diffraction, and crystallizability with an interplanar spacing of 0.39 nm was possessed. This monomolecular film had approximately the same crystallizability as that of a monomolecular film containing terthiophene. In addition, in infrared measurement of the monomolecular film, absorption derived from an amino group was confirmed at a wavelength of 3500 to 3300 cm⁻¹. Thereby, it was confirmed that the monomolecular film has an amino group.

Subsequently, a toluene solution containing 10mM of a terthiophene derivative which is the following compound: 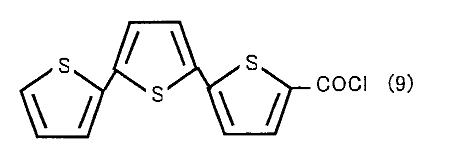 was prepared, the monomolecular film was immersed in the solution for an hour, slowly pulled up and washed with a solvent to form a second monomolecular film on the first monomolecular film, to prepare an accumulated film shown in Fig. 1 (c).

Regarding the resulting accumulated film, from measurement of a film thickness by ellipsometry, the result of 2.6 nm corresponding to a molecular length was obtained. In addition, in infrared measurement of a monomolecular film, absorption derived from an amido group was confirmed at a wavelength of 3200 cm⁻¹. Thereby, it was confirmed that an accumulated film having a structure in which silicon compounds containing a group derived from terthiophene which is a π -electron coupled molecule are laminated is formed on the substrate via an amido bond.

An organic thin film transistor in which the thus prepared organic thin film was used as a semiconductor layer, and the accumulated film was used as a semiconductor layer, was prepared. The resulting organic thin film transistor had a field-effect mobility equivalent to that of an organic thin film transistor using the terthiophenetrichlorosilane, and a current value became 2-fold or more, and better performance was obtained.

In an example of preparation of an organic thin film transistor using an accumulated film as a semiconductor layer, an example of lamination using the amido bond of the terthiophenetrichlorosilane film was shown, but any bond species may be used as far as a first layer and a second layer are chemically bound. In addition, regarding a compound species to be laminated, herein, terthiophene which is one of π -elecron coupled molecules was explained, but any chemical species may be used as far as it is a π -electron coupled molecule.

### Example 13: Preparation of organic thin film transistor using 2-octyl-quinquethiphenetriethoxysilane

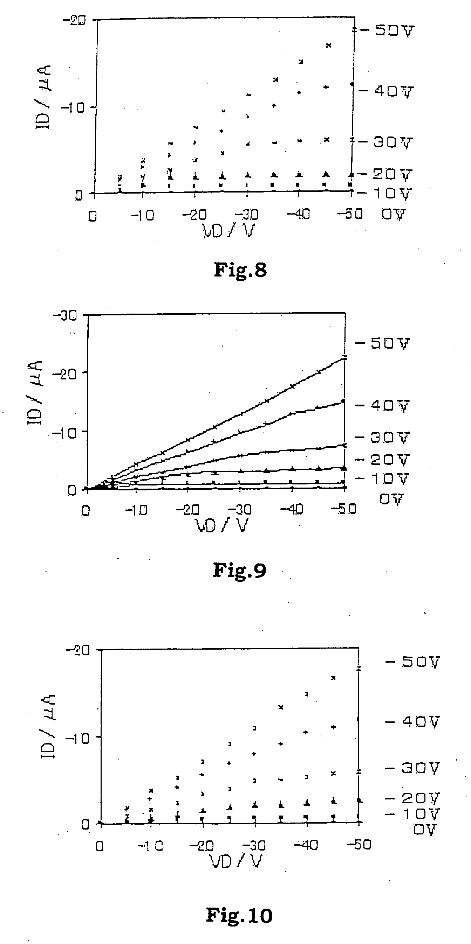

As in Example 11, a prepared substrate equipped with an electrode was immersed in a solution of 5mM 2-octyl-quinquethiophenetriethoxysilane in a mixed solution of toluene and hydrochloric acid for a constant time (e.g. 10 minutes) to form a 2-octyl-quinquethiophenetriethoxysilane film, thereby, an organic semiconductor layer was formed to form an organic thin film transistor. Properties of the formed organic thin film transistor are shown in Fig. 8. From this result, the formed organic thin film transistor had a field-effect mobility of 1.5×10⁻¹ cm²/Vs, and an on/off ratio of about 6 order.

### Example 14: Preparation of organic thin film transistor using 2-dodecyl-septithiophenetrichlorosilane

As in Example 11, a prepared substrate equipped with an electrode was immersed in a toluene solution of 2mM 2-dodecyl-septithiophenetriethoxysilane for a constant time (e.g. 5 minutes) to form a 2-dodecyl-septithiophenetrichlorosilane film, thereby, an organic semiconductor layer was formed to form an organic thin film transistor. Properties of the formed organic thin film transistor are shown in Fig. 9. From this result, the formed organic thin film transistor had a field-effect mobility of 1.7×10⁻¹ cm²/Vs, and an on/ off ratio of about 6 order.

### Example 15: Preparation of organic thin film transistor using 2-hexadecyl-quaterphenyltrimethoxysilane

As in Example 11, a prepared substrate equipped with an electrode was immersed in a toluene solution of 3mM 2-hexadecyl-quarterphenyltrimethoxysilane for a constant time (e.g. 60 minutes) to form a 2-hexadecyl-quarterphenyltrimethoxysilane film, thereby, an organic semiconductor layer was formed to form an organic thin film transistor. Properties of the formed organic thin film transistor are shown in Fig. 10. From this result, the formed organic thin film transistor had a field-effect mobility of 1.3×10⁻¹ cm²/Vs, and an on/off ratio of about 6 order.

### Example 16: Preparation of organic thin film transistor using 2-hexadecyl-octiphenyltrimethoxysilane

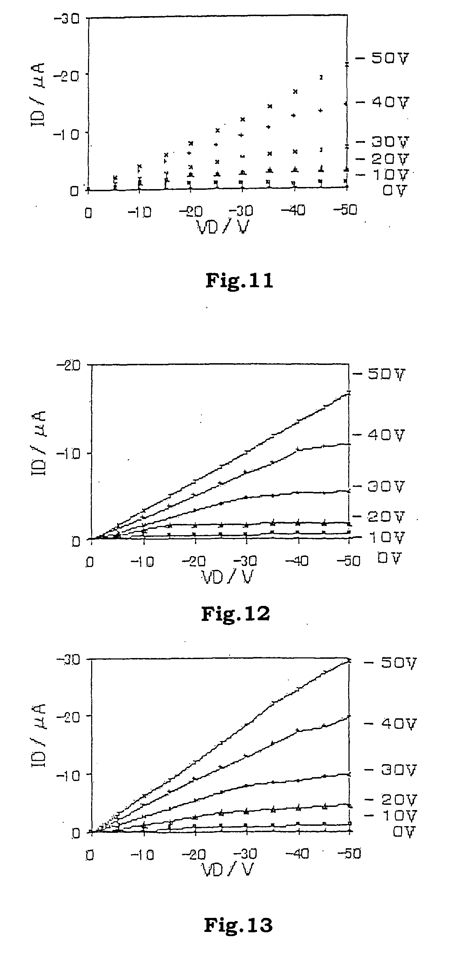

As in Example 11, a prepared electrode equipped with an electrode was immersed in a toluene solution of 3mM 2-hexadecyl-octiphenyltrimethoxysilane for a constant time (e.g. 60 minutes) to form a 2-hexadecyl-octiphenyltrimethoxysilane film, thereby, an organic semiconductor layer was formed to form an organic thin film transistor. Properties of the formed organic thin film are shown in Fig. 11. From this result, the formed organic thin film transistor had a field-effect mobility of 1.6×10⁻¹ cm²/Vs, and an on/off ratio of about 6 order.

### Example 17: Preparation of organic thin film transistor using organic silicon compound (E) n₁=n₃=2, n₂=1

As in Example 11, a prepared substrate equipped with an electrode was immersed in a THT solution of an organic silicon compound represented by (E) at a concentration of 1mM for a constant time (e.g. 15 minutes), thereby, a compound thin film was formed. Like this, an organic semiconductor layer was formed, and an organic thin film transistor was formed. Properties of the formed organic thin film transistor are shown in Fig. 12. From this result, the formed organic thin film transistor had a field-effect mobility of 1.1×10⁻¹ cm²/Vs, and an on/off ratio of about 6 order.

### Example 18: Preparation of organic thin film transistor using organic silicon compound (F) n₄=n₆=2, n₅=3

As in Example 11, a prepared substrate equipped with an electrode was immersed in a xylene solution of an organic silicon compound represented by (F) at a concentration of 1mM for a constant time (e.g. 10 minutes), thereby, the compound thin film was formed. Like this, an organic semiconductor layer was formed, and an organic thin film transistor was formed. Properties of the formed organic thin film transistor are shown in Fig. 13. From this result, the formed organic thin film transistor had a field-effect mobility of 2.2×10⁻¹ cm²/Vs, and an on/ off ratio of about 6 order.

### Example 19: Synthesis of an organic silicon compound (E; n₁=n₃=2, n₂=3) having the following structure

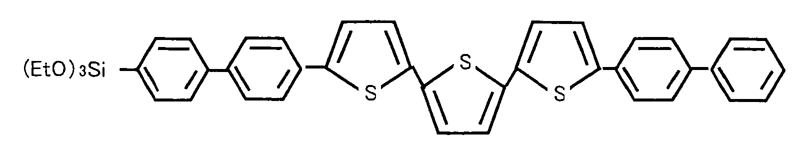

The above compound was synthesized by the following procedure. That is, an intermediate 1 and an intermediate 2 are formed from dibromodiphenyl. Separately, an intermediate 3 is formed from terthiophene and Grignard reagent (see the following content). These are coupling-reacted to form an objective compound. Specifically, the procedure is as follows:

### Formation of intermediate 1

First, in a 500 ml glass flask equipped with a stirrer, a reflux condenser, a thermometer and a dropping funnel, 1.5 mole of a metal magnesium and 200 ml of toluene were put, a toluene solution of 0.5 mole of dibromobiphenyl was added over 30 minutes. After the adding having been completed, this was aged at 65°C for 2 hours to prepare Grignard reagent in which one bromo group was substituted. Subsequently, in 1 liter of glass flask equipped with a stirrer, a reflux condenser, a thermometer and a dropping funnel, 1.0 mole of tetrachlorosilane and 200 ml of toluene were put and cooled with ice, to which the Grignard reagent was added at an internal temperature of 15°C over an hour. After addition, this was aged for an hour. Subsequently, the reaction solution was filtered under reduced pressure to remove unreacted substances, this was dissolved in diethyl ether, and placed into a 500ml glass flask equipped with a stirrer, a reflux condenser, a thermometer and a dropping funnel, an ether solution of 1.0 mole CH₃-CH₂-O-MgBr was added dropwise over an hour, and this was refluxed at 70°C for 12 hours to form an intermediate 1 (yield 60%).

### Formation of intermediate 2

First, in a 500 ml glass flask equipped with a stirrer, a reflux condenser, a thermometer and a dropping funnel, 0.5 mole of n-butyllithium were put, this was cooled to -78°C, the intermediate 1 was added over 30 minutes using a dropping funnel, subsequently, 1.5 mole of bis(pinacolato)diboron was added, and an internal temperature of the container was elevated over 12 hours from -78°C to room temperature to proceed that reaction. After the reaction having been completed, 2M hydrochloric acid was added to form an intermediate 2 (yield 60%).

### Formation of intermediate 3

First, 1.6 mole of terthiophene was dissolved in carbon tetrachloride, NBS was added, azobisisobutyronitrile (AIBN) which is a polymerization initiator was added, and the mixture was stirred for 6 hours, and filtered under reduced pressure to obtain dibromoterthiophene.

Separately, 1.6 mole of biphenyl was dissolved in carbon tetrachloride, NBS was added, this was stirred for 2 hours in the presence of AIBN to form bromodiphenyl, subsequently, in a 500 ml glass flask equipped with a stirrer, a reflux condenser, a thermometer and a dropping funnel, 1.5 mole of a metal magnesium and 200 ml of toluene were put, a toluene solution of 0.5 mole of bromodiphenyl was added over 30 minutes and, after the addition having been completed, this was aged at 65°C for 2 hours to prepare Grignard reagent.

Subsequently, dibromoterthiophene was dissolved in diethyl ether, this was placed into a 500 ml glass flask equipped with a stirrer, a reflux condenser, a thermometer and a dropping funnel, the Grignard reagent was added dropwise over 2 hours and, thereafter, this was refluxed for 18 hours to proceed the reaction. Thereafter, the reaction mixture was filtered under reduced pressure, and unreacted substances were stripped to obtain an intermediate 3 (yield 50%).

### Formation of an objective compound

A toluene solution of the intermediate 2, 3 mol% Pd (PPh)₃ and a small amount of an aqueous sodium carbonate solution were successively placed into a 500 ml glass flask equipped with a stirrer, a reflux condenser, a thermometer and a dropping funnel, subsequently, a toluene solution of the intermediate 3 was added using a dropping funnel, and the mixture was reacted at 85°C for 12 hours to form an objective compound (Suzuki coupling).

Regarding the formed objective compound, an infrared absorption spectrum was measured, absorption derived from SiC was confirmed at 1065cm⁻¹, and it was confirmed that the compound contains a SiC bond. Further, nuclear magnetic resonance of the compound was measured.
7.5 ppm to 7.2 ppm (m) (17H phenyl skeleton-derived)
7.1 ppm to 6.9 ppm (m) (6H thiophene skeleton-derived)
3.8 ppm to 3.7 ppm (m) (6H methylene-derived in ethoxy group)
1.4 ppm to 1.2 ppm (m) (9H methyl group-derived in ethoxy group)

From these results, it was confirmed that the compound is a compound represented by the aforementioned structural formula.

### Example 21

### Synthesis of anorganic silicon compound (J; n_{γ} =2) having the following structural formula

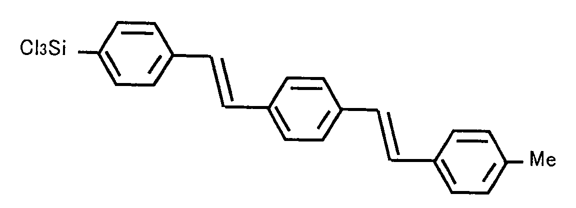

The aforementioned compound was synthesized by the following procedure.

First, in a 200 ml of round-bottom flask, α-bromoxylene (50mM) and triethyl phosphite (60mM) were put, and its temperature was elevated to 140°C while stirring, to proceed the reaction. Further, the temperature was elevated to 180°C to destruct remaining of triethyl phosphite, and this was cooled to form 4-(methyl-benzyl)-phosphonic acid. Subsequently, 10mM sodium hydroxide was added to dry DMF under the argon atmosphere in a 500ml glass flask equipped with a stirrer, a thermometer and a dropping funnel, the solution temperature was adjusted to 0°C, a DMF solution (50ml) of the 4-(methyl-benzyl)-phosphonic acid (8mM) and trans-4-stilbenecarboxaldehyde (7mM) was slowly added, and the mixture was stirred for 24 hours to proceed the reaction. After the reaction having been completed, the product was extracted by ethanol to obtain 4-{(E)-2-[4-{(E)-2-phenylvinyl}-phenyl]-vinyl}-phenylmethane (Compound G). Then, the compound G was dissolved in carbon tetrachloride, NBS was added, AIBN was added, the mixture was stirred for 2 hours, and filtered under reduced pressure to synthesize an intermediate 4 shown by the following structural formula.

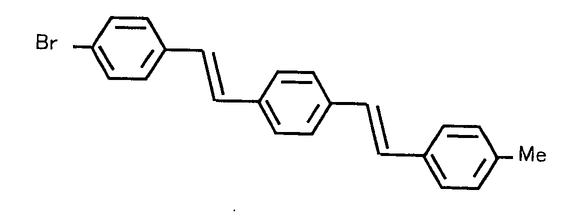

Subsequently, the intermediate 4 was placed into a 500 ml glass flask equipped with a stirrer, a reflux condenser, a thermometer and a dropping funnel, 1.0 mole of tetrachlorosilane and 200 ml of toluene were placed therein, the mixture was cooled with ice, the intermediate 4 was added dropwise at an internal temperature of 10°C over an hour and, after addition, the reaction mixture was aged for an hour to synthesize the compound represented by the above structural formula.

Regarding the formed objective compound, an infrared absorption spectrum was measured, absorption derived from SiC was confirmed at 1070cm⁻¹, and it was confirmed that the compound contains a SiC bond. Further, nuclear magnetic resonance of the compound was measured. Since this compound has high reactivity, and NMR can not be directly measured, the compound was reacted with ethanol, and terminal chlorine was converted into an ethoxy group and, thereafter, measurement was performed.
7.4 ppm to 7.2 ppm (m) (12H phenyl skeleton-derived)
7.1 ppm to 7.0 ppm (m) (4H vinyl group skeleton-derived)
3.8 ppm to 3.7 ppm (m) (6H methylene-derived in ethoxy group)
2.5 ppm to 2.4 ppm (m) (3H methyl group-derived)
1.4 ppm to 1.2 ppm (m) (9H methyl group-derived in ethoxy group)

From these results, it was confirmed that this compound is a compound represented by the above structural formula.

According to the present invention, since the compound of the formula (I) is chemically adsorbed onto a substrate by a two-dimensional network of Si-O-Si formed between silicon compounds having a π -electron conjugated molecule and, at the same time, intermolecular interaction exerting on π -electron conjugated molecules which is a near distance force necessary for crystallizing a film exerts effectively, a film which has very high stability and is highly crystallized can be constructed. Therefore, physical peeling can be prevented by firmly adsorbing the resulting film onto a substrate surface firm, as compared with a film prepared on a substrate by physical adsorption.

Moreover, the aforementioned compound can be simply prepared.

In addition, a network derived from a silicon compound constituting an organic thin film and an organic residue constituting an upper part are directly bound and, by a network derived from a silicon compound and intermolecular interaction of a π -conjugated molecule, an organic thin film having high ordering property (crystallizability) can be formed. Thereby, a carrier is smoothly moved by hopping conduction in a direction vertical to a molecular plane. In addition, since high electric conductivity also in a molecular axial direction is obtained, the film as an electric conductive material can be widely applied not only to an organic thin film transistor material, but also to a solar cell, a fuel cell and a sensor.

Further, the organic thin film of the present invention comprising the aforementioned silicon compound can form a stacked structure by interaction between units, so that the film has high electric conductivity in a direction vertical to a substrate surface, and overlapping of orbits between units is effectively obtained in a planar direction. For this reason, a film exhibiting electric anisotropy such as having excellent electric conductivity and semiconductor property is obtained. That is, since a distance between π -electron conjugated units possessed at an upper part of a network becomes small, electric conductivity in a direction vertical to a unit binding direction rises, by hopping conduction. In addition, a film having high semiconductor property in a unit binding direction is obtained.

Further, according to the present invention, it becomes possible to simply prepare the aforementioned organic thin film.

In addition, according to the present invention, an organic thin film can be formed by a monomolecular film of a silicon compound in which a plurality of π -electron conjugated units are bound, or an accumulated monomolecular film in which those monomolecular films are laminated. For this reason, both of a chemical structure of an organic material, and a higher structure of a film, for example, crystallizability, that is, orienting property of a molecule which are factors determining property of a thin film can be realized. As a result, since a stacked structure can be formed by intermolecular interaction so that the film has high electric conductivity in a direction vertical to a substrate surface, and overlapping of orbits between molecules is effectively obtained in a surface direction, electric anisotropy such as having excellent semiconductor property is exhibited.

Further, an organic thin film being very thin with several tens Å, comprising a monomolecular film having high electric conductivity in a direction vertical to a unit binding direction, and having high semiconductor property in a unit binding direction can be utilized in a semiconductor layer of organic TFT. That is, by controlling an amount of injection of a charge such as a hole and an electron in a monomolecular film by applying a voltage between a source electrode-drain electrode and a gate electrode-drain electrode, and changing a voltage between a gate electrode and a drain electrode, a high performance organic thin film transistor can be provided.

Further, in other words, by utilizing carrier hopping conduction between π -electron coupled units contained in a molecule constituting an organic thin film, when a voltage is not applied between a gate electrode and a drain electrode, a current flowing between a source electrode-drain electrode can be more decreased, and an off current can be suppressed small. Moreover, when a voltage is applied between a gate electrode-drain electrode, a current flowing between a source electrode-a drain electrode can be increased.

In particular, by using an organic molecule having a silanol group at a terminus, a self-organizing monomolecular film can be chemically adsorbed onto a hydrophilic substrate surface in an organic solvent. For this reason, a thin film having a highly ordered structure can be formed. Therefore, miniaturization of a transistor can be attained.

Moreover, since an organic thin film can use a self-organizing monomolecular film, it is not necessary to perform orientation treatment as pre-treatment upon construction of an organic thin film, and simple preparation become possible. That is, by a simple method of slowly placing a constant amount of pure water on a substrate having a hydrophilized surface, and adding dropwise a constant amount of an organic solvent containing a silicon compound containing a π-electron conjugated unit to the pure water, to form a two-dimensional network of Si-O-Si on an interface between water and an organic solvent, and evaporating pure water to make a silicon compound adsorbed onto a substrate, an organic thin film can be prepared. As a result, it becomes possible to easily prepare a high performance transistor.

## Claims

1. A functional organic thin film comprising a film made on a substrate using a silicon compound represented by the formula:
R-SiX¹X²X³ (I)
,wherein R is an organic residue in which a plurality of π-electron conjugated units having a terminus optionally substituted with a functional group are bound, and X¹, X² and X³ are, the same or different, a group which affords hydroxyl group by hydrolysis.

2. The functional organic thin film according to claim 1, wherein the functional organic thin film is bound on the substrate by a siloxane bond.

3. The functional organic thin film according to claim 1, wherein the organic residue is a π-electron conjugated organic residue in which 3 to 10 units bond in straight manner.

4. The functional organic thin film according to claim 1, wherein the unit is selected from the group derived from a monocyclic aromatic hydrocarbon, a polycyclic aromatic hydrocarbon, a monocyclic heterocycle compound, a polycyclic heterocycle compound, an alkene, an alkadiene and an alkatriene.

5. The functional organic thin film according to claim 4, wherein the unit is phenylene, thiophendiyl or ethylene group.

6. The functional organic thin film according to claim 1, wherein all of the X¹, X² and X³ are the same kind of a halogen atom or a lower alkoxy group.

7. The functional organic thin film according to claim 1, wherein the functional organic thin film is a monomolecular film derived from the silicon compound or a repeated film of the monomolecular film, and the thickness of the monomolecular film is 1 nm to 12nm.

8. The functional organic thin film according to claim 1, wherein the functional organic thin film has molecular crystallinity.

9. The functional organic thin film according to claim 1, wherein the functional organic thin film has electric anisotropy in which electroconductive property in a vertical direction and semi-electroconductive property in a surface direction relative to a substrate surface is showed.

10. A process for preparing a functional organic thin film comprising forming a functional organic thin film on a substrate by a chemical adsorption method using a silicon compound represented the formula:
R-SiX¹X²X³ (I)
, wherein R is an organic residue in which a plurality of π-electron conjugated units having a terminus optionally substituted with a functional group are bound, and X¹, X² and X³ are, the same or different, is a group which affords hydroxyl group by hydrolysis.

11. A functional organic thin film comprising a first monomolecular film derived from a silicon compound represented by the formula:
R-SiX¹X²X³ (I)
, wherein R is an organic residue in which a plurality of π-electron conjugated units having a terminus optionally substituted with a functional group are bound, and X¹, X² and X³ are, the same or different, a group which affords hydroxyl group by hydrolysis,
and a second monomolecular film containing a silicon compound in which a plurality π -electron conjugated units are bound on a substrate, said second monomolecular film being formed on the first monomolecular film at the number of one or more.

12. The functional organic thin film according to claim 11, wherein the second monomolecular film is a film formed using a compound represented by the formula:
K²-R'-K³ (IV)
, wherein R' is an organic residue in which a plurality of π-electron conjugated units, and K² and K³ are a functional group or hydrogen atom, provided that they are not hydrogen atom at the same time.

13. A process for preparing a functional organic thin film comprising steps of: making a first monomolecular film on a substrate by a chemical adsorption method using a silicon compound represented by the formula:
R-SiX¹X²X³ (I)
, wherein R is an organic residue in which a plurality of π-electron conjugated units having a terminus optionally substituted with a functional group are bound, and X¹, X² and X³ are, the same or different, a group which affords hydroxyl group by hydrolysis, and forming at least one second monomolecular film containing a silicon compound in which a plurality of π -electron conjugated units are bound, on the first monomolecular film using a chemical adsorption method.

14. An organic thin film transistor comprising a substrate, an organic thin film of a monomolecular film of a silicon compound represented by the formula:
R-SiX¹X²X³ (I)
, wherein R is an organic residue in which a plurality of π -electron conjugated units having a terminus optionally substituted with a functional group are bound, and X¹, X² and X³ are, the same or different, a group which affords a hydroxyl group by hydrolysis, or an accumulated monomolecular film; a gate electrode which is formed on one surface of the organic thin film via a gate insulating film, and source/drain electrodes formed in contact with one surface or the other surface of the organic thin film on both sides of the gate electrode.

15. The organic thin film transistor according to claim 11, wherein the gate electrode is arranged on the substrate, the organic thin film is arranged on the gate electrode via the gate insulating film, and source/drain electrodes are arranged on the organic thin film, the gate insulating film and gate electrode are bonded via a siloxane bond, Rs which are adjacent in a substrate surface direction are not bounded each other.

16. The organic thin film transistor according to claim 14, wherein the units bond in straight manner.

17. The organic thin film transistor according to claim 14, wherein the organic thin film is bound on the substrate by a siloxane bond.

18. The organic thin film transistor according to claim 14, wherein 3 to 10 of the units are bonded.

19. The organic thin film transistor according to claim 14, wherein the unit is selected from the group derived from a monocyclic aromatic hydrocarbon, polycyclic aromatic hydrocarbon, monocyclic heterocycle compound, polycyclic heterocycle compound, alkene, alkadiene and alkatriene.

20. The organic thin film transistor according to claim 19, wherein the unit is phenylene, thiophendiyl or ethylene group.

21. The organic thin film transistor according to claim 14, wherein all of X¹, X² and X³ are the same kind of a halogen atom or a lower alkoxy group.

22. The organic thin film transistor according to claim 14, wherein the organic thin film is a monomolecular film derived from the silicon compound or a repeated film of the monomolecular film, and the thickness of the monomolecular film is 1nm to 12nm.

23. The organic thin film transistor according to claim 14, wherein the organic thin film shows molecular crystallinity.

24. The organic thin film transistor according to claim 14, wherein the organic thin film has electric anisotropy in which electroconductive property in a vertical direction and semi- electroconductive property in a surface direction relative to a substrate surface is showed.

25. An organic thin film transistor comprising a substrate, an organic thin film, a gate electrode formed on one surface of the organic thin film via an insulating film, and source/drain electrodes formed in contact with one surface or the other surface of the organic thin film on both sides of the gate electrode, wherein the organic thin film comprises a first monomolecular film formed using a silicon compound represented by the formula:
R-SiX¹X²X³ (I)
, wherein R is an organic residue in which a plurality of π -electron conjugated units having a terminus optionally substituted with a functional group are bound, and X¹, X² and X³ are, the same or different, a group which affords hydroxyl group by hydrolysis,
and at least one second monomolecular film containing a silicon compound in which a plurality of π -electron conjugated units are bound, formed on the first monomolecular film.

26. The organic thin film transistor according to claim 25, wherein the second monomolecular film is a film formed using a compound represented by the formula:
K²-R'-K³ (IV)
, wherein R' is an organic residue in which a plurality of π -electron conjugated units, and K² and K³ are a functional group or hydrogen atom provided that they are not hydrogen atom at the same time.

27. A process for preparing an organic thin film transistor comprising a substrate, an organic thin film, a gate electrode formed on one surface of the organic thin film via a gate insulating film, and source/drain electrodes formed in contact with one surface or the other surface of the organic thin film on both sides of the gate electrode, which comprises forming the organic thin film as a monomolecular film or an accumulated monomolecular film, using a silicon compound represented by the formula:
R-SiX¹X²X³ (I)
, wherein R is an organic residue in which a plurality of π -electron conjugated units having a terminus optionally substituted with a functional group are bound, and X¹, X² and X³ are, the same or different, a group which affords hydroxyl group by hydrolysis.

28. A process for preparing an organic thin film transistor comprising a substrate, an organic thin film, a gate electrode formed on one surface of the organic thin film via a gate insulating film, and source/drain electrodes formed in contact with one surface or the other surface of the organic thin film on both sides of the gate electrode, which comprises the steps of
making a first monomolecular film on a substrate by a chemical absorption method using a silicon compound represented by the formula:
R-SiX¹X²X³ (I)
, wherein R is an organic residue in which a plurality of π -electron conjugated units having a terminus optionally substituted with a functional group are bound, and X¹, X² and X³ are, the same or different, a group which affords hydroxyl group by hydrolysis, and
forming at least one second monomolecular film comprising a silicon compound in which a plurality of π -electron conjugated units are bound, on the first monomolecular film using a chemical adsorption method.

29. A π -electron conjugated molecule-containing silicon compound represented by the formula:
R¹-SiX¹X²X³ (I)'
, wherein R is an organic residue in which a plurality of π -electron conjugated units having a terminus optionally substituted with a functional group are bound, and X¹, X² and X³ are, the same or different, a group which affords hydroxyl group by hydrolysis.

30. A π -electron conjugated molecule-containing silicon compound represented by the formula:
R¹-SiX¹X²X³ (I)'
,wherein R¹ is a π -electron conjugated organic residue in which 3 to 10 units selected from the group derived from a monocyclic aromatic hydrocarbons and a monocyclic heterocycle compound are bound, and may have a functional group at a terminus, and X¹, X² and X³ are, the same or different, a group which affords hydroxyl group by hydrolysis.

31. The π -electron conjugated molecule-containing silicon compound according to claim 30, wherein R¹ is an organic residue having a vinylene group between units.

32. The π -electron conjugated molecule-containing silicon compound according to claim 30, wherein the monocyclic aromatic hydrocarbon and heteromonocyclic compound is benzene or thiophene.

33. The π -electron conjugated molecule-containing silicon compound according to claim 30, wherein all of the X¹, X² and X³ are the same kind of a halogen atom or a lower alkoxy group.

34. A process for preparing a π -electron conjugated molecule-containing silicon compound, comprising reacting a compound represented by the formula:
R¹-Li (II)'
,wherein R¹ is a π -electron conjugated organic residue in which 3 to 10 units selected from the group derived from a monocyclic aromatic hydrocarbon and a heteromonocyclic compound are bound, and may have a functional group at a terminus, with a compound represented by the formula:
Y-SiX¹X²X³ (III)'
,wherein X¹, X² and X³ are, the same or different, a group which affords hydroxyl group by hydrolysis, and Y is hydrogen atom, a halogen atom or a lower alkoxy group,
to obtain a π -electron conjugated molecule-containing silicon compound represented by the formula:
R¹-SiX¹X²X³ (I)'
,wherein R¹, X¹, X² and X³ are as defined above.

35. A process for preparing a π -electron conjugated molecule-containing silicon compound, comprising subjecting a compound represented by the formula:
R¹-MgX (IV)'
, wherein R¹ is a π -electron conjugated organic residue in which 3 to 10 units selected from groups derived from monocyclic aromatic hydrocarbons and heteromonocyclic compounds are bound, and may have a functional group at a terminus, X is a hydrogen atom, a halogen atom or a lower alkoxy group,
and a compound represented by the formula:
Y-SiX¹X²X³ (III)'
, wherein X¹, X² and X³ are, the same or different, a group which affords hydroxyl group by hydrolysis, and Y is a hydrogen atom, a halogen atom or a lower alkoxy group, to Grignard reaction to obtain a π -electron conjugated molecule-containing silicon compound represented by the formula:
R¹-SiX¹X²X³ (I)'
, wherein R¹, X¹, X² and X³ are as defined above.

36. The process for preparing a π -electron conjugated molecule-containing silicon compound according to claim 34 or 35, wherein the group R derives from a compound obtained by combining a prescribed number of raw materials which is obtained by one or more repetition of halogenating the raw material selected from a monocyclic aromatic hydrocarbon and a monocyclic heterocyclic compound at its prescribed position, followed by subjecting to Grignard reaction.

37. The process for preparing a π -electron conjugated molecule-containing silicon compound according to claim 34 or 35, wherein the unit constituting the group R derives from thiophene and the group R derives from a compound combined a prescribed number of thiophenes which is obtained by one or more repetition of halogenating thiophene at its prescribed position, followed by reacting the resulting halogenated thiophene in the presence of NCS or POCl₃.

38. The process for preparing a π -electron conjugated molecule-containing silicon compound according to claim 34 or 35, wherein the unit constituting the group R derives from thiophene and the group R derives from a compound combined a prescribed number of thiophenes which is formed by one or more repetition of the steps of halogenating thiophene at its prescribed position, reacting the resulting halogenated thiophene with vinyl sulfone to form 1,4-diketone compound combined both sides of succinyl radical with the halogenated thiophene and ring-closing the 1,4-diketone compound in the presence of Lawesson reagent or P₄S₁₀.

39. The process for preparing a π -electron conjugated molecule-containing silicon compound according to claim 34 or 35, wherein the group R derives from a compound combined a prescribed number of raw materials which is obtained by one ore more repetition of the steps of halogenating a methyl group in the raw material selected from a monocyclic aromatic hydrocarbon and monocyclic heterocycle compound having a methyl group (s) at prescribed position (s) , substituting halogen atoms in the resulting halogenated methyl group with a pentavalent phosphorus compound and reacting the resulting compound with a raw material selected from a monocyclic aromatic hydrocarbon and monocyclic heterocycle compound having aldehyde group (s) at prescribed positions.
